(19) Europäisches Patentamt
European Patent Office
Office européen des brevets

(11) EP 4 797 321 A1

(12) **EUROPEAN PATENT APPLICATION**
published in accordance with Art. 153(4) EPC

(43) Date of publication:
**26.08.2026 Bulletin 2026/35**

(21) Application number: **24896949.5**

(22) Date of filing: **04.06.2024**

(51) International Patent Classification (IPC):
***H01L 21/60*** *(2006.01)* ***C22C 21/02*** *(2006.01)*
***C22F 1/00*** *(2006.01)* ***C22F 1/043*** *(2006.01)*

(52) Cooperative Patent Classification (CPC):
**C22C 1/026; C22F 1/043; H10W 72/50;** C22C 21/02

(86) International application number:
**PCT/JP2024/020313**

(87) International publication number:
**WO 2025/115257 (05.06.2025 Gazette 2025/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:
**27.11.2023 PCT/JP2023/042366**
**27.11.2023 PCT/JP2023/042369**
**27.11.2023 PCT/JP2023/042371**
**27.11.2023 PCT/JP2023/042373**
**27.11.2023 PCT/JP2023/042374**

(71) Applicants:
- **NIPPON STEEL CHEMICAL & MATERIAL CO., LTD.**
**Tokyo 103-0027 (JP)**
- **Nippon Micrometal Corporation**
**Iruma-shi**
**Saitama 358-0032 (JP)**

(72) Inventors:
- **UNO, Tomohiro**
**Tokyo 100-8071 (JP)**
- **OYAMADA, Tetsuya**
**Tokyo 100-8071 (JP)**
- **ODA, Daizo**
**Iruma-shi, Saitama 358-0032 (JP)**
- **ETO, Motoki**
**Iruma-shi, Saitama 358-0032 (JP)**
- **SUTO, Yuya**
**Tokyo 100-8071 (JP)**

(74) Representative: **Grünecker Patent- und Rechtsanwälte**
**PartG mbB**
**Leopoldstraße 4**
**80802 München (DE)**

(54) **AL CONNECTION MATERIAL**

(57) To provide an Al connection material that satisfies excellent temperature cycle reliability and favorable 1st bonding strength. The Al connection material containing 3.0 mass% or more and 12.0 mass% or less of Si, wherein, when crystal orientations of an Al phase in an L cross-section of the Al connection material are measured, a total of orientation ratios of a <111> crystal orientation and a <110> crystal orientation angled at 15° or less to a center axis direction is equal to or larger than 20% and equal to or smaller than 70%, provided that, when the total of the orientation ratios is equal to or smaller than 25%, an orientation ratio of the <110> crystal orientation angled at 15° or less to the center axis direction is equal to or larger than 5%, and when crystal orientations of a Si phase in the L cross-section of the Al connection material are measured, orientation ratios of the <111> crystal orientation and the <110> crystal orientation angled at 15° or less to the center axis direction are equal to or larger than 20% and equal to or smaller than 70%.

EP 4 797 321 A1

## Description

## TECHNICAL FIELD

The present invention relates to an Al connection material.

## BACKGROUND ART

In a semiconductor device, electrodes formed on a semiconductor chip are connected with a lead frame or electrodes on a substrate via a bonding wire (wire material) or a bonding ribbon (strip material). In a power semiconductor device, a bonding wire or a bonding ribbon made mainly of aluminum (Al) as a material is used. A wire diameter of the Al bonding wire mainly falls within a range from 100 μm to 600 μm. A width of the Al bonding ribbon mainly falls within a range from 100 μm to 3000 μm, and a thickness thereof falls within a range from 50 μm to 600 μm. Herein, the Al bonding wire and the Al bonding ribbon are collectively referred to as an Al connection material.

In the power semiconductor device, silicon (Si) is often used as a material of a semiconductor chip, and an Al-Si alloy or an Al-Cu alloy is often used as a material of the electrode formed on the semiconductor chip. Power semiconductor devices using the Al connection material are often used as large power equipment such as air conditioners and photovoltaic power generation systems, or as vehicle-mounted semiconductor devices.

A bonding method for the Al connection material includes 1st bonding with the electrode on the semiconductor chip and 2nd bonding with the lead frame or the electrode on the substrate, and wedge bonding is used for both of them. The wedge bonding is a method for applying ultrasonic vibrations and loads to the Al connection material via a jig (tool) made of metal, breaking surface oxide films of the Al connection material and an electrode material to expose new surfaces, and performing solid phase diffusion bonding. This connection method is characterized in that the connection material is connected in a solid phase state without being melted, which is a bonding technique different from a welding technique of melting the connection material.

A next-generation power semiconductor device is required to stably operate for a long time as compared with a general-purpose power semiconductor device. The power semiconductor device operates while repeatedly turning on and off a current. When a current is supplied to a semiconductor chip made of Si via the Al connection material, a temperature of a 1st bonding part rises. On the other hand, when supply of the current is stopped, the temperature of the 1st bonding part falls. In this way, the temperature of the 1st bonding part repeatedly rises and falls at the time when the power semiconductor operates. Accordingly, thermal stress, which is caused by a thermal expansion difference between the Al connection material and the semiconductor chip, is repeatedly applied to the 1st bonding part. In a case of using a connection material made only of high-purity Al, the Al connection material is broken in a relatively short time due to thermal stress, so that it has been difficult to satisfy performance required for the next-generation power semiconductor device. Thus, in the next-generation power semiconductor, it is required to improve a lifetime of wire (or ribbon) bond accompanying a temperature rise and a temperature fall of the 1st bonding part (hereinafter, also referred to as "temperature cycle reliability").

In response to the requirement for the temperature cycle reliability, there has been developed an Al bonding wire focused on improvement in mechanical strength. As a method for improving a mechanical characteristic of the Al bonding wire, there has been developed a method for adding a specific element to Al.

Patent Literature 1 discloses a bonding wire made of an Al alloy containing at least magnesium (Mg) and silicon (Si), in which a total content of Mg and Si is equal to or larger than 0.03 mass% and equal to or smaller than 0.3 mass%. This Patent Literature discloses that lowering of bonding strength of the 1st bonding part is delayed in a thermal cycle test in a temperature range from 70°C to 120°C due to a high-strengthening effect exhibited by solid-solution strengthening of Mg or Si, and an effect of suppressing crack development exhibited by precipitated magnesium silicide ($Mg_2Si$).

Patent Literature 2 discloses a bonding wire made of an alloy containing 0.01 to 0.2 mass% of iron (Fe), 1 to 20 mass ppm of silicon (Si), and Al having purity of 99.997 mass% or more as a balance, in which a solid solution amount of Fe is 0.01 to 0.06%, a precipitation amount of Fe is 7 times or less the Fe solid solution amount, and the bonding wire has a fine structure having an average crystal grain size of 6 to 12 μm. This Patent Literature discloses that it is possible to suppress lowering of bonding strength of a 1st bonding part in a thermal shock test within a temperature range from -50°C to 200°C by uniformly dispersing intermetallic compound particles of Fe and Al in Al to improve mechanical strength of a matrix and further refining recrystallized grains.

Patent Literature 3 discloses a bonding wire made by melting an Al-Si alloy containing 0.1 to 5 mass% of silicon (Si), and Al and impurities as a balance, and jetting and rapidly cooling it to be formed into a thin wire. This Patent Literature discloses that mechanical strength is improved by rapidly cooling the melted Al-Si alloy to finely and uniformly disperse Si.

## RELATED ART REFERENCE

**Patent Literature**

Patent Literature 1: Japanese Patent Application Laid-open No. 2014-131010
Patent Literature 2: Japanese Patent Application Laid-open No. 2014-129578
Patent Literature 3: Japanese Patent Application Laid-open No. S59-57440

## SUMMARY OF INVENTION

## PROBLEM TO BE SOLVED BY THE INVENTION

As described above, the next-generation power semiconductor device is required to withstand a longer-time use as compared with a general-purpose power semiconductor device. The temperature of the 1st bonding part repeatedly rises and falls at the time when the power semiconductor device operates. As a result, because the Al connection material has a coefficient of linear thermal expansion larger than that of the semiconductor chip, there has been a case in which thermal stress is caused due to a difference between coefficients of linear thermal expansion thereof at the 1st bonding part, which finally causes fatigue breakdown of the Al connection material. A temperature cycle test is one of the tests for evaluating, in an accelerated manner, a lifetime of wire (or ribbon) bond accompanying a temperature rise and a temperature fall of the 1st bonding part (temperature cycle reliability). The Al connection material used for the next-generation power semiconductor is required to exhibit excellent temperature cycle reliability in the temperature cycle test. However, in a case of using the Al connection material that is highly strengthened by adding Si and the like thereto as disclosed in Patent Literatures 1 to 3, it has been confirmed that there is a problem in that a crack develops at a relatively high speed in an Al alloy electrode having lower strength than that of the Al connection material in a temperature cycle test assuming a use in the next-generation power semiconductor device, and favorable temperature cycle reliability is difficult to be stably obtained.

Furthermore, when a bonding defect such as peeling of the Al connection material from the electrode occurs at the time of performing bonding, this leads to a product defect or a reduction in manufacturing yield, so that it is required to obtain favorable bonding strength at each bonding part. In this regard, at the 1st bonding part, when ultrasonic vibrations or loads are strongly applied in order to obtain favorable bonding strength, the semiconductor chip may be damaged. In particular, in a case of using an Al connection material that is highly strengthened by adding Si and the like thereto, the semiconductor chip is likely to be damaged at the time of the 1st bonding due to hardness thereof, and when ultrasonic vibrations or loads are adjusted in order to reduce such damage, sufficient bonding strength of the 1st bonding part (hereinafter, also simply referred to as "1st bonding strength") cannot be obtained in some cases because a bonding area cannot be stably secured due to high deformation resistance, instability in a deformation direction, or the like. These problems at the time of initial bonding of the 1st bonding part eventually become factors of a reduction or instability in temperature cycle reliability, and therefore constitute an obstacle to practical use of an Al connection material that is highly strengthened by adding Si and the like thereto.

The present invention aims at providing an Al connection material that satisfies excellent temperature cycle reliability and favorable 1st bonding strength.

## MEANS FOR SOLVING PROBLEM

As a result of earnest investigation as to the problem described above, the present inventors have found that the problem described above can be solved by an Al connection material containing 3.0 mass% or more and 12.0 mass% or less of Si, in which a total of orientation ratios of a <111> crystal orientation and a <110> crystal orientation of an Al phase in an L cross-section (cross section in a center axis direction including a center axis) of the Al connection material and an orientation ratio of the <110> crystal orientation of a Si phase in the L cross-section fall within a specific range, and further investigated the problem based on such knowledge to complete the present invention.

Advantageous Effects of Invention

That is, the present invention includes the following content.

<1> An Al connection material containing 3.0 mass% or more and 12.0 mass% or less of Si, wherein,

when crystal orientations of an Al phase in an L cross-section (cross section in a center axis direction including a center axis) of the Al connection material are measured, a total of orientation ratios of a <111> crystal orientation

and a <110> crystal orientation angled at 15° or less to the center axis direction is equal to or larger than 20% and equal to or smaller than 70%, provided that, when the total of the orientation ratios is equal to or smaller than 25%, an orientation ratio of the <110> crystal orientation angled at 15° or less to the center axis direction is equal to or larger than 5%, and

when crystal orientations of a Si phase in the L cross-section of the Al connection material are measured, a total of orientation ratios of the <111> crystal orientation and the <110> crystal orientation angled at 15° or less to the center axis direction is equal to or larger than 20% and equal to or smaller than 70%.

<2> The Al connection material according to <1>, wherein, regarding crystal orientations of the Al phase in the L cross-section, an orientation ratio of the <110> crystal orientation angled at 15° or less to the center axis direction is equal to or larger than 5% and equal to or smaller than 40%.
<3> The Al connection material according to <1> or <2>, wherein an average diameter of the Al phase in the L cross-section is equal to or larger than 5 $\mu$m and equal to or smaller than 40 $\mu$m.
<4> The Al connection material according to any one of <1> to <3>, wherein an average value of a ratio between a short side length e and a long side length f (e/f) of the Si phase in the L cross-section is equal to or larger than 0.2 and equal to or smaller than 0.7.
<5> The Al connection material according to any one of <1> to <4>, further containing 10 mass ppm or more and 800 mass ppm or less of one or more of Sr, Ca, Eu, and Sb in total.
<6> The Al connection material according to any one of <1> to <5>, further containing 10 mass ppm or more and 500 mass ppm or less of one or more of Ni, Mg, Fe, and In in total.
<7> The Al connection material according to any one of <1> to <6>, wherein a total concentration of other elements in the Al connection material is equal to or smaller than 0.5 mass%.

## EFFECT OF THE INVENTION

According to the present invention, it is possible to provide an Al connection material that satisfies excellent temperature cycle reliability and favorable 1st bonding strength.

## BRIEF DESCRIPTION OF DRAWINGS

FIG. 1 is a schematic diagram for explaining a measurement target surface (inspection surface) at the time of measuring crystal orientations, average diameters, and shapes of an Al phase and a Si phase for an Al connection material. The measurement target surface is a cross section in a center axis direction including a center axis (L cross-section) of the Al connection material.
FIG. 2 is a schematic diagram for explaining a short side length (e) and a long side length (f) of the Si phase in the L cross-section.
FIG. 3 is a schematic diagram for explaining a hollow defect of a 1st bonding part.

## EMBODIMENT FOR CARRYING OUT THE INVENTION

Hereinafter, the present invention will be described in detail with reference to preferable embodiments thereof. While the drawings may be referred to for description, each of the drawings merely schematically illustrates shapes, sizes, and arrangement of constituent elements to the extent that the invention can be understood. The present invention is not limited to the following embodiments and examples, and may be optionally changed to be implemented without departing from CLAIMS of the present invention and equivalents thereof.

[Al connection material]

The Al connection material according to the present invention is an Al connection material containing 3.0 mass% or more and 12.0 mass% or less of Si, wherein,

when crystal orientations of an Al phase in an L cross-section (cross section in a center axis direction including a center axis) of the Al connection material are measured, a total of orientation ratios of a <111> crystal orientation and a <110> crystal orientation angled at 15° or less to the center axis direction is equal to or larger than 20% and equal to or smaller than 70%, provided that, when the total of the orientation ratios is equal to or smaller than 25%, an orientation ratio of the <110> crystal orientation angled at 15° or less to the center axis direction is equal to or larger than 5%, and

when crystal orientations of a Si phase in the L cross-section of the Al connection material are measured, a total of orientation ratios of the <111> crystal orientation and the <110> crystal orientation angled at 15° or less to the center axis direction is equal to or larger than 20% and equal to or smaller than 70%.

As described above, in a case of using a connection material composed only of high-purity Al in a temperature cycle test, a crack develops at a relatively high speed inside the connection material, and it has been difficult to obtain favorable temperature cycle reliability. On the other hand, in a case of using an Al connection material that is highly strengthened by adding Si and the like thereto, a crack develops in an Al alloy electrode having relatively low strength, so that it has been confirmed that it is difficult to obtain temperature cycle reliability required for a next-generation power semiconductor device. Furthermore, in a case of using an Al connection material that is highly strengthened by adding Si and the like thereto, the semiconductor chip is likely to be damaged at the time of the 1st bonding, and when ultrasonic vibrations or loads are adjusted in order to reduce such damage, sufficient 1st bonding strength cannot be obtained in some cases.

As a result of earnest investigation to solve the problems described above, the present inventors have found that, with an Al connection material containing 3.0 mass% or more and 12.0 mass% or less of Si, in which a total of orientation ratios of a <111> crystal orientation and a <110> crystal orientation of the Al phase in the L cross-section thereof and a total of orientation ratios of a <111> crystal orientation and a <110> crystal orientation of a Si phase in the L cross-section fall within a specific range, temperature cycle reliability can be improved and 1st bonding strength can also be improved. The Al connection material according to the present invention significantly contributes to achieving temperature cycle reliability required for the next-generation power semiconductor device and achieving favorable 1st bonding strength.

The Al connection material according to the present invention contains 3.0 mass% or more and 12.0 mass% or less of Si and is constituted of the Al phase in which Si is dissolved in Al as a solid solution and the Si phase formed by crystallization or precipitation of Si. In the Al phase, other additive elements may be dissolved as a solid solution in addition to Si. The Si phase is a general term for Si crystallized products and Si precipitates. The Si crystallized product is formed from a solution during solidification, and has a size of about 1 to 20 μm, which is coarse. On the other hand, the Si precipitate is formed from a solid state, and has a small size of about 0.1 μm to several micrometers.

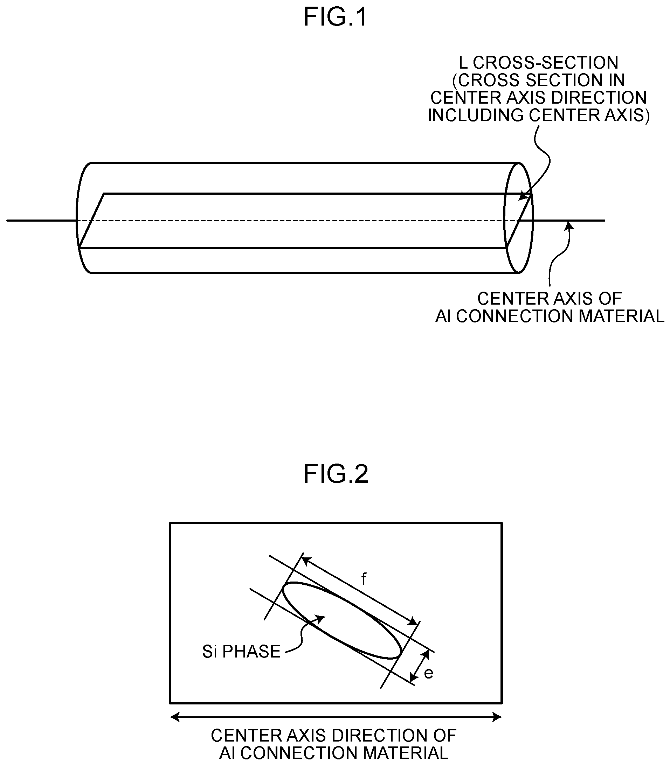

In the present invention, the L cross-section of the Al connection material, that is, the cross section in the center axis direction including the center axis of the Al connection material, will be described later in "(Method for measuring orientation ratios of crystal orientations of Al phase and Si phase)" with reference to FIG. 1.

The reason why the Al connection material according to the present invention can provide excellent temperature cycle reliability and favorable 1st bonding strength is estimated as follows.

First, regarding the temperature cycle reliability, a coefficient of linear thermal expansion of the Si phase is smaller than that of Al, so that it is considered that the Si phase may contribute to reduction of a difference in the coefficient of linear thermal expansion between the Al connection material and the semiconductor chip and may further reduce generated thermal stress, and the particulate Si phase may suppress growth of a crack generated at a bonding interface to the inside of the Al connection material. Furthermore, it is considered that, when a total of orientation ratios of the <111> crystal orientation and the <110> crystal orientation of the Al phase falls within a range equal to or larger than 20% and equal to or smaller than 70% (provided that, when the total of the orientation ratios is equal to or smaller than 25%, an orientation ratio of the <110> crystal orientation angled at 15° or less to the center axis direction is equal to or larger than 5%), an effect of increasing a yield force in the center axis direction in the temperature cycle test or reducing slip deformation can be obtained, and furthermore, when a total of the orientation ratios of the <111> crystal orientation and the <110> crystal orientation of the Si phase falls within a range equal to or larger than 20% and equal to or smaller than 70%, an effect of reducing stress concentration around the Si phase can be obtained.

Regarding the 1st bonding strength, it is considered that, by setting orientation ratios of crystal orientations of the Al phase and the Si phase within the range of the present invention, deformation of the Al phase and rotation of a crystal lattice in the vicinity of the bonding interface that are caused when ultrasonic vibrations or loads are applied are controlled, and thus the bonding strength is improved. That is, when a total of orientation ratios of the <111> crystal orientation and the <110> crystal orientation of the Al phase falls within a range equal to or larger than 20% and equal to or smaller than 70% (provided that, when the total of the orientation ratios is equal to or smaller than 25%, an orientation ratio of the <110> crystal orientation angled at 15° or less to the center axis direction is equal to or larger than 5%), an effect of accelerating deformation of the Al connection material in a direction perpendicular to the center axis to enhance adhesion at the bonding interface can be obtained, and when a total of the orientation ratios of the <111> crystal orientation and the <110> crystal orientation of the Si phase falls within a range equal to or larger than 20% and equal to or smaller than 70%, an effect of controlling deformation of the Al connection material in the center axis direction can be obtained. It is considered that, by controlling the crystal orientations of the Al phase and the crystal orientations of the Si phase at the same time, deformation of the Al connection material in both of the direction perpendicular to the center axis and the center axis direction is accelerated, and an effect of accelerating metallic bonding by breaking an oxide film at the bonding interface is enhanced.

As described above, it can be estimated that the Al connection material according to the present invention can

provide excellent temperature cycle reliability and favorable 1st bonding strength as described above, as a result of appropriate control of factors contributing to improvement of temperature cycle reliability and 1st bonding strength.

-Si concentration-

A Si concentration in a range equal to or larger than 3.0 mass% and equal to or smaller than 12.0 mass% is useful in reducing thermal distortion of the bonding part and improving a temperature cycle characteristic. If the Si concentration is smaller than 3.0 mass%, an improvement effect is small. If the Si concentration exceeds 12.0 mass%, there are problems such as lowering of initial bonding strength due to hardening, or damage to the semiconductor chip. From a viewpoint of obtaining favorable temperature cycle reliability, the concentration of Si in the Al connection material according to the present invention is equal to or larger than 3.0 mass%, preferably equal to or larger than 4.0 mass%, more preferably equal to or larger than 4.2 mass%, equal to or larger than 4.4 mass%, equal to or larger than 4.5 mass%, equal to or larger than 4.6 mass%, equal to or larger than 4.8 mass%, or equal to or larger than 5.0 mass%. On the other hand, if hardness of the Al connection material becomes excessive, the semiconductor chip tends to be easily damaged at the time of 1st bonding under a bonding condition with ultrasonic vibrations and loads that are generally used. From a viewpoint of obtaining favorable bonding strength in a case of performing 1st bonding under a general bonding condition, the Si concentration in the Al connection material according to the present invention is equal to or smaller than 12.0 mass%, preferably equal to or smaller than 11.5 mass% or equal to or smaller than 11.0 mass%, more preferably equal to or smaller than 10.8 mass%, equal to or smaller than 10.6 mass%, equal to or smaller than 10.5 mass%, equal to or smaller than 10.4 mass%, equal to or smaller than 10.2 mass%, or equal to or smaller than 10.0 mass%.

For concentration analysis of elements contained in the Al connection material according to the present invention, for example, an Inductively Coupled Plasma (ICP) emission spectrophotometer or an ICP mass spectrometer can be used. In a case in which elements derived from contaminants in the air, such as oxygen or carbon, are adsorbed on a surface of the Al connection material, it is effective to clean it with acid or alkali depending on adsorbed substances before performing analysis.

-Crystal orientation of Al phase in L cross-section-

From a viewpoint of obtaining excellent temperature cycle reliability and favorable 1st bonding strength, when crystal orientations of the Al phase in the L cross-section of the Al connection material are measured, a total of orientation ratios of the <111> crystal orientation and the <110> crystal orientation angled at 15° or less to the center axis direction (hereinafter, also referred to as a "<111>+<110> total ratio of the Al phase") is equal to or larger than 20%, preferably equal to or larger than 22%, equal to or larger than 24%, equal to or larger than 25%, or larger than 25%, more preferably equal to or larger than 26% or equal to or larger than 28%, still more preferably equal to or larger than 30%, and even more preferably equal to or larger than 35%, equal to or larger than 40%, equal to or larger than 42%, equal to or larger than 44%, or equal to or larger than 45%. As a result of detailed examination of an aspect in which the <111>+<110> total ratio of the Al phase is low, it has been confirmed that, even when the total ratio falls within a range equal to or larger than 20% and smaller than 30%, an effect of improving temperature cycle reliability and 1st bonding strength can be obtained. However, it has been confirmed that, when the <111>+<110> total ratio of the Al phase is equal to or smaller than 25%, it is important that an orientation ratio of the <110> crystal orientation angled at 15° or less to the center axis direction is equal to or larger than 5%. From a viewpoint of obtaining excellent temperature cycle reliability and favorable 1st bonding strength, an upper limit of the <111>+<110> total ratio of the Al phase is equal to or smaller than 70%, preferably equal to or smaller than 65%, more preferably equal to or smaller than 60%, still more preferably equal to or smaller than 58%, equal to or smaller than 56%, or equal to or smaller than 55%.

From a viewpoint of obtaining more favorable 1st bonding strength, and from a viewpoint of suppressing a hollow at the 1st bonding part (a phenomenon in which a portion where metallic bonding is insufficient is formed in a bonding region between the Al connection material and an electrode), when crystal orientations of the Al phase in the L cross-section of the Al connection material are measured, an orientation ratio of the <110> crystal orientation angled at 15° or less to the center axis direction (hereinafter, also referred to as a "<110> ratio of the Al phase") preferably falls within a range equal to or larger than 5% and equal to or smaller than 40%. That is, regarding the crystal orientations of the Al phase, by satisfying the above condition that the <111>+<110> total ratio of the Al phase falls within a range equal to or larger than 20% and equal to or smaller than 70%, and by setting the <110> ratio of the Al phase to be equal to or larger than 5% and equal to or smaller than 40%, a high effect of suppressing a hollow at the 1st bonding part and improving the 1st bonding strength can be obtained. The reason why the above effect can be obtained in a case in which the <110> ratio of the Al phase falls within such a range is estimated as follows. That is, it is considered that, when the <110> ratio of the Al phase falls within such a range, deformation of the Al connection material in an ultrasonic vibration direction can be accelerated, and the 1st bonding strength can be further improved. Furthermore, a hollow is often generated in the ultrasonic vibration direction, so that it is considered that a hollow is suppressed by accelerating deformation of the Al connection material in

the ultrasonic vibration direction as described above. From a viewpoint of obtaining more favorable 1st bonding strength, and from a viewpoint of suppressing a hollow at the 1st bonding part, the <110> ratio of the Al phase is more preferably equal to or larger than 10%, still more preferably equal to or larger than 12%, equal to or larger than 14%, or equal to or larger than 15%. An upper limit of the <110> ratio of the Al phase is more preferably equal to or smaller than 38%, equal to or smaller than 36%, or equal to or smaller than 35%.

In measuring the orientation ratios of the crystal orientations of the Al phase in the L cross-section of the Al connection material, a method of combining information of Al concentration and Si concentration obtained by SEM-EDS and information of a crystal orientation obtained by Electron BackScatter Diffraction (EBSD) can be used. Specifically, in a measurement region assuming that the L cross-section of the Al connection material is an inspection surface, measurement of concentration of Al and Si using the EDS and crystal orientation analysis using the EBSD are performed at the same time. Subsequently, the Al phase and the Si phase are separated and extracted from a measurement result of the EDS by using analysis software attached to the apparatus. Specifically, it is preferable to use Chi Scan function, which is a function of analysis software OIM Data Collection or OIM Analysis (both manufactured by TSL solutions KK) attached to an FE-SEM apparatus. For a region specified as the Al phase, the orientation ratios of the <111> crystal orientation and the <110> crystal orientation of the Al phase and a total thereof can be calculated by using the analysis software attached to the apparatus. In calculating the orientation ratio, a partial ratio is used, the partial ratio being calculated by using, as a population, an area of only crystal orientations that have been identified based on certain reliability within a measurement area. Orientation ratio of the <111> crystal orientation and the <110> crystal orientation are defined as an orientation ratio of the <111> crystal orientation and an orientation ratio of the <110> crystal orientation, respectively. Thus, in one embodiment, the orientation ratio of the crystal orientation of the Al phase in the L cross-section of the Al connection material according to the present invention is calculated through procedures from (1) to (3) as follows.

(1) In the measurement region designating the L cross-section of the Al connection material to be the inspection surface, measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using crystal information of Al and Si from a material file.
(3) For a region specified as the Al phase, the crystal orientations are analyzed, and the orientation ratio of the <111> crystal orientation and the orientation ratio of the <110> crystal orientation of the Al phase are calculated.

In the procedure of (2) described above, setting of Tolerance (%) can be selected from a range from 20 to 40%, and about 30% is preferable for comparison in standard analysis of the L cross-section of the Al connection material. The following supplementarily describes a procedure of adjusting the Tolerance. It is preferable to select or confirm a numerical value of Tolerance so that the shape and the size of the Si phase extracted and identified by the Chi Scan function are equivalent to the shape and the size of the Si phase identified from an EDS map in which Si element concentration by EDS analysis is two-dimensionally displayed.

In the present invention, the orientation ratio of the <111> crystal orientation and the orientation ratio of the <110> crystal orientation of the Al phase in the L cross-section are calculated as average values of respective values of the orientation ratios obtained by measuring at three or more parts. In selecting the measurement region, from a viewpoint of securing objectivity of measurement data, it is preferable to acquire a sample for measurement to be measured from the Al connection material as a measurement target at intervals of 50 cm or more with respect to the center axis direction of the Al connection material. In the present invention, the measurement region for the crystal orientation measured by the EBSD method is preferably determined so that the length in the center axis direction of the Al connection material is equal to or larger than 300 μm and smaller than 800 μm, and the entire Al connection material is accommodated therein in the direction perpendicular to the center axis of the Al connection material, but if the size is large and the entire region is difficult to be measured, it can be adjusted in a range smaller than 600 μm.

-Crystal orientation of Si phase in L cross-section-

From a viewpoint of obtaining excellent temperature cycle reliability and favorable 1st bonding strength, when crystal orientations of the Si phase in the L cross-section of the Al connection material are measured, a total of orientation ratios of the <111> crystal orientation and the <110> crystal orientation angled at 15° or less to the center axis direction (hereinafter, also referred to as a "<111>+<110> total ratio of the Si phase") is equal to or larger than 20%, preferably equal to or larger than 25%, and more preferably equal to or larger than 26%, equal to or larger than 28%, or equal to or larger than 30%. From a viewpoint of obtaining excellent temperature cycle reliability and favorable 1st bonding strength, the <111>+<110> total ratio of the Si phase is equal to or smaller than 70%, preferably equal to or smaller than 65%, more preferably equal to or smaller than 60%, and still more preferably equal to or smaller than 58%, equal to or smaller than

56%, equal to or smaller than 55%, equal to or smaller than 54%, equal to or smaller than 52%, or equal to or smaller than 50%.

In measuring the orientation ratios of the crystal orientations of the Si phase in the L cross-section of the Al connection material, similarly to measurement of the orientation ratios of the crystal orientations of the Al phase, a method of combining information of Al concentration and Si concentration obtained by the SEM-EDS and information of a crystal orientation obtained by the EBSD can be used. A specific procedure is the same as that described above in relation to measurement of the orientation ratios of the crystal orientations of the Al phase, that is, for a region specified as the Si phase, the orientation ratios of the <111> crystal orientation and the <110> crystal orientation of the Si phase and a total thereof can be calculated by using the analysis software attached to the apparatus. In calculating the orientation ratio, a partial ratio is used, the partial ratio being calculated by using, as a population, an area of only crystal orientations that have been identified based on certain reliability within a measurement area. Thus, in one embodiment, the orientation ratio of the crystal orientation of the Si phase in the L cross-section of the Al connection material according to the present invention is calculated through procedures from (1) to (3) as follows.

(1) In the measurement region designating the L cross-section of the Al connection material to be the inspection surface, measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using crystal information of Al and Si from a material file.
(3) For a region specified as the Si phase, the crystal orientations are analyzed, and the orientation ratio of the <111> crystal orientation and the orientation ratio of the <110> crystal orientation of the Si phase are calculated.

In the present invention, the orientation ratio of the <111> crystal orientation and the orientation ratio of the <110> crystal orientation of the Si phase in the L cross-section are calculated as average values of respective values of the orientation ratios obtained by measuring at three or more parts. A setting range of Tolerance in the procedure of (2) described above, a method of acquiring a sample for measurement, and the measurement region of crystal orientation by the EBSD method are the same as those described above regarding measurement of the orientation ratios of the crystal orientations of the Al phase.

-Average diameter of Al phase in L cross-section-

In the Al connection material according to the present invention, an average diameter of the Al phase in the L cross-section is preferably equal to or larger than 5 μm and equal to or smaller than 40 μm.

As a target of the 2nd bonding, a material harder than Al such as a substrate made of Cu is used in many cases, and conditions of ultrasonic vibrations or loads at the time of 2nd bonding are set to be higher than those at the time of 1st bonding, so that deformation of the Al connection material that is highly strengthened by adding Si and the like thereto tends to be unstable at the time of 2nd bonding. From this viewpoint, the present inventors have found that variations in bonding strength in the 2nd bonding can be reduced when the average diameter of the Al phase in the L cross-section falls within the range equal to or larger than 5 μm and equal to or smaller than 40 μm. A reason for this is considered to be a synergistic effect of accelerating deformation of the Al connection material by ultrasonic vibrations by containing the predetermined concentration of Si and controlling the orientation ratios of the crystal orientations of the Al phase and the Si phase to fall within a predetermined range, and uniformizing deformation of the Al connection material in both directions parallel with and perpendicular to the center axis of the Al connection material by setting the average diameter of the Al phase to be equal to or larger than 5 μm and equal to or smaller than 40 μm.

From a viewpoint of further reducing variations in the bonding strength in the 2nd bonding to achieve stability of more favorable bonding strength, the average diameter of the Al phase in the L cross-section of the Al connection material according to the present invention is more preferably equal to or larger than 10 μm, and more preferably equal to or larger than 12 μm, equal to or larger than 14 μm, or equal to or larger than 15 μm. An upper limit of the average diameter of the Al phase in the L cross-section is more preferably equal to or smaller than 35 μm, more preferably equal to or smaller than 30 μm, and even more preferably equal to or smaller than 28 μm, equal to or smaller than 26 μm, or equal to or smaller than 25 μm.

The following describes a method for measuring the average diameter of the Al phase in the L cross-section of the Al connection material. In measuring the average diameter of the Al phase in the L cross-section, similarly to measurement of the orientation ratios of the crystal orientations described above, a method of combining information of Al concentration and Si concentration obtained by the SEM-EDS and information of crystal orientations obtained by the EBSD can be used. A specific procedure is the same as that described above in relation to measurement of the orientation ratios of the crystal orientations, that is, the crystal orientation can be analyzed for a region specified as the Al phase by using the analysis

software attached to the apparatus. If an orientation difference between measurement points is equal to or larger than 15°, it is determined to be a crystal grain boundary, and an equivalent circle diameter is calculated. An average value of equivalent circle diameters of respective Al phases is defined as the average diameter of the Al phase. In a process of obtaining the average diameter of the Al phase, calculation is performed excluding a part in which the crystal orientation cannot be measured, and a part in which the crystal orientation can be measured but reliability of orientation analysis is low. Thus, in one embodiment, the average diameter of the Al phase in the L cross-section of the Al connection material according to the present invention is calculated through procedures from (1) to (3) as follows.

(1) The L cross-section of the Al connection material is designated as the inspection surface, and measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using crystal information of Al and Si from a material file.
(3) For the region that is specified as the Al phase, the crystal orientation is analyzed, and if the orientation difference between measurement points is equal to or larger than 15°, it is determined to be the crystal grain boundary, and the equivalent circle diameter of each crystal grain is obtained. An average of equivalent circle diameters of the respective crystal grains is calculated to obtain the average diameter of the Al phase. Herein, regarding average calculation, an average value obtained by Area average, which can be selected by the software attached to the apparatus, is employed. By employing the average value obtained by Area average, it is possible to accurately measure and determine whether a condition is met, the condition being related to the average diameter of the Al phase that is suitable for improving stability of the bonding strength in the 2nd bonding. In the calculation of Area average, the average value is calculated from an average of values obtained by multiplying a ratio of an area of each particle to areas of all particles by an area value of each particle, which is automatically computed by software.

In the present invention, in calculating the average diameter of the Al phase in the L cross-section, only Al phases having a diameter (equivalent circle diameter) equal to or larger than 0.5 μm are considered as targets. Due to this, it is possible to accurately determine whether a requirement is met, the requirement being related to the average diameter of the Al phase in the L cross-section that is suitable for improving stability of the bonding strength in the 2nd bonding.

In measuring the average diameter of the Al phase in the L cross-section, a setting range of Tolerance in the procedure of (2) described above, a method of acquiring a sample for measurement, and a measurement region of crystal orientation by the EBSD method are the same as those described above regarding measurement of the orientation ratios of the crystal orientations of the Al phase.

-Shape of Si phase in L cross-section-

When bonding strength of a plurality of wires has been evaluated in the temperature cycle test, it has been confirmed that a plurality of bonding parts do not deteriorate at the same time, but there is variation in a failure time (lifetime) at which the bonding strength is lowered. In achieving temperature cycle reliability required for the next-generation power semiconductor device, not only management of a lifetime based on an average value of bonding strength in the temperature cycle test but also control of variation in bonding strength is required.

In a process of conducting studies on the Al connection material containing 3.0 mass% or more and 12.0 mass% or less of Si, in which the <111>+<110> total ratio of the Al phase in the L cross-section thereof and the <111>+<110> total ratio of the Si phase in the L cross-section fall within a specific range, the present inventors have found that the shape of the Si phase in the L cross-section affects variation in bonding strength in the temperature cycle test. Specifically, it has been found that, when an average value of a ratio of a short side length e to a long side length f (e/f) of the Si phase in the L cross-section falls within a range equal to or larger than 0.2 and equal to or smaller than 0.70, variation in bonding strength is reduced in addition to an effect of suppressing deterioration of bonding strength after the temperature cycle test. A numerical value of this ratio (e/f) is an index indicating flatness. Description will be further made with reference to FIG. 2. FIG. 2 is a diagram schematically illustrating the Si phase in the L cross-section of the Al connection material so that the center axis direction of the Al connection material corresponds to a horizontal direction (right and left direction) of FIG. 2, and a direction perpendicular to the center axis corresponds to a vertical direction (upper and lower direction) of FIG. 2. Regarding the Si phase in the L cross-section, the "short side length e" described above corresponds to a dimension indicated by a sign "e" in FIG. 2. Regarding the Si phase in the L cross-section, the "long side length f" described above corresponds to a dimension indicated by a sign "f" in FIG. 2. Hereinafter, the ratio between the short side length e and the long side length f (e/f) of the Si phase in the L cross-section may also be referred to as a "shape ratio (e/f) of the Si phase". A numerical value of the shape ratio (e/f) of the Si phase can be obtained as Grain Shape Aspect Ratio by the analysis software attached to the apparatus.

In the Al connection material according to the present invention, the reason why variation in bonding strength in the temperature cycle test can be reduced by controlling an average value of the shape ratio (e/f) of the Si phase is estimated as follows. A factor causing bonding strength to decrease in the temperature cycle test is that a crack develops inside the Al connection material or at the bonding interface along the center axis direction of the Al connection material or a direction close thereto. Herein, due to plastic work by wire drawing, the Si phase tends to be arranged such that a direction of the long side length f thereof becomes the center axis direction of the Al connection material or a direction close thereto. It is considered that, when the average value of the shape ratio (e/f) of the Si phase falls within a range equal to or larger than 0.2 and equal to or smaller than 0.70, the Si phase has a shape such as an ellipse or a column, an action of relieving thermal stress in the center axis direction of the Al connection material is exhibited, and development of a crack along the center axis direction of the Al connection material or a direction close thereto can be suppressed. To achieve reduction in variation of the bonding strength in the temperature cycle test, it is sufficient that the average value of the shape ratio (e/f) of the Si phase in the L cross-section falls within the preferred range described above, and shape ratios (e/f) of all Si phases do not necessarily fall within the range equal to or larger than 0.2 and equal to or smaller than 0.70. For example, the Si phase having the shape ratio (e/f) smaller than 0.2 may be included, or the Si phase having the shape ratio (e/f) exceeding 0.70 may be included.

From a viewpoint of reducing variation in bonding strength in the temperature cycle test and more favorably achieving temperature cycle reliability required for the next-generation power semiconductor device, an average value of the shape ratio (e/f) of the Si phase in the L cross-section of the Al connection material according to the present invention is more preferably equal to or larger than 0.25. From a viewpoint of achieving more favorable temperature cycle reliability, an upper limit of the average value of the shape ratio (e/f) of the Si phase is more preferably equal to or smaller than 0.6.

The following describes a method for measuring the shape ratio (e/f) of the Si phase in the L cross-section of the Al connection material. First, similarly to the measurement of the crystal orientation and measurement of the average diameter of the Al phase described above, a method of combining information of Al concentration and Si concentration obtained by the SEM-EDS and information of a crystal orientation obtained by the EBSD can be used. A specific procedure is the same as that described above in relation to measurement of the orientation ratios of the crystal orientations, that is, the crystal orientation can be analyzed for a region specified as the Si phase by using the analysis software attached to the apparatus. If an orientation difference between measurement points is equal to or larger than 15°, it is determined to be a crystal grain boundary, and the shape ratio (e/f) is calculated. An average value of shape ratios (e/f) of the respective Si phases is defined as the average value of the shape ratio (e/f) of the Si phase. In a process of obtaining the shape ratio (e/f) of the Si phase, calculation is performed excluding a part in which the crystal orientation cannot be measured, and a part in which the crystal orientation can be measured but reliability of orientation analysis is low. Thus, in one embodiment, the average value of the shape ratio (e/f) of the Si phase in the L cross-section of the Al connection material according to the present invention is calculated through procedures from (1) to (3) as follows.

(1) The L cross-section of the Al connection material is designated as the inspection surface, and measurement of concentration of Al and Si using the EDS and crystal orientation measurement using the EBSD are performed at the same time.

(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using crystal information of Al and Si from a material file.

(3) For the region that is specified as the Si phase, the crystal orientation is analyzed, and if the orientation difference between measurement points is equal to or larger than 15°, it is determined to be the crystal grain boundary and the shape ratios (e/f) of respective crystal grains are obtained, and an average of the shape ratios (e/f) of the respective crystal grains is calculated to obtain the average value of the shape ratio (e/f) of the Si phase. Herein, as the average value of the shape ratio (e/f) of the Si phase, a numerical value of Grain Shape Aspect Ratio of the analysis software (hereinafter, referred to as a "grain shape aspect ratio") is used. This numerical value is an average value obtained by calculating an average of grain shape aspect ratios of the respective crystal grains. Regarding a method for calculating the grain shape aspect ratio, a ratio (e/f) between a short side length (e) (Grain Shape Minor Axis) and a long side length (f) (Grain Shape Major Axis) of one crystal grain is obtained. Regarding average calculation, an average value obtained by Area average, which can be selected by the software attached to the apparatus, is employed. By employing the average value obtained by Area average, it is possible to accurately measure and determine whether a condition relating to the average value of the shape ratio (e/f) of the Si phase is met, the condition being suitable for reducing variation in bonding strength in the temperature cycle test and more favorably achieving temperature cycle reliability required for the next-generation power semiconductor device.

In measuring the average value of the shape ratio (e/f) of the Si phase in the L cross-section, a setting range of Tolerance in the procedure of (2) described above and a measurement region of crystal orientation by the EBSD method are the same as those described above regarding measurement of the orientation ratios of the crystal orientations of the Al

phase.

Examples of the method for measuring the average diameter of the Al phase and the shape ratio (e/f) of the Si phase include several methods including binarization processing from an observation image of the L cross-section in addition to the methods described above. The present invention uses the method of combining information of Al concentration and Si concentration obtained by the SEM-EDS and information of crystal orientation obtained by the EBSD as described above since the provision of numerous measuring functions allows multiple characteristics such as the crystal orientation, the average diameter of the Al phase, and the shape ratio (e/f) of the Si phase to be obtained in one measurement, automatic analysis can be performed, and measurement can be easily performed with a widespread apparatus and analysis technique.

-Addition of Sr, Ca, Eu, and Sb-

The Al connection material according to the present invention may further contain 10 mass ppm or more and 800 mass ppm or less of one or more of Sr, Ca, Eu, and Sb (hereinafter, also referred to as a "first element group") in total.

By further containing 10 mass ppm or more and 800 mass ppm or less of one or more of Sr, Ca, Eu, and Sb in total, a generation frequency of wire breakage can be reduced in wire-drawing processing for the Al connection material. In an Al alloy containing a high concentration of Si equal to or larger than 3.0 mass% and equal to or smaller than 12.0 mass%, a frequency of wire breakage at a wire-drawing step tends to be increased. This may be because particles of the Si phase crystallized at the time of solidification cause stress concentration during the wire-drawing processing, and induce wire breakage. It is estimated that stress concentration during wire-drawing can be relieved and wire breakage can be reduced due to effects such that the particulate Si phase may be uniformly distributed, and/or growth and coarsening of the Si phase may be suppressed by adding the first element group. It is considered that an effect of relieving stress concentration during wire-drawing can be enhanced by controlling the orientation ratios of the crystal orientations of the Al phase and the Si phase in the L cross-section and adding the first element group thereto.

From a viewpoint of reducing the generation frequency of wire breakage in the wire-drawing processing, a total concentration of the first element group in the Al connection material according to the present invention is more preferably equal to or larger than 20 mass ppm, even more preferably equal to or larger than 30 mass ppm, equal to or larger than 40 mass ppm, or equal to or larger than 50 mass ppm, and an upper limit thereof is preferably equal to or smaller than 750 mass ppm, and more preferably equal to or smaller than 740 mass ppm, equal to or smaller than 720 mass ppm, or equal to or smaller than 700 mass ppm.

-Addition of Ni, Mg, Fe, and In-

The Al connection material according to the present invention may further contain 10 mass ppm or more and 500 mass ppm or less of one or more of Ni, Mg, Fe, and In (hereinafter, also referred to as a "second element group") in total.

By further containing 10 mass ppm or more and 500 mass ppm or less of one or more of Ni, Mg, Fe, and In in total, generation of scratches and scrapes on the surface of the Al connection material can be suppressed, and a smooth surface can be formed. In an Al alloy containing a high concentration of Si equal to or larger than 3.0 mass% and equal to or smaller than 12.0 mass%, scratches and/or scrapes may be generated on a surface thereof during the wire-drawing processing, and may result in the Al connection material with large surface unevenness when the surface is hardened or the Si phase and Al oxide present on the surface are dropped. It is estimated that scratches and scrapes during the wire-drawing processing can be reduced by adding the second element group to accelerate stabilization of the Al oxide on the surface of the Al connection material, refinement and hardening of structures of Al crystal grains, and the like. It is considered that an effect of suppressing scratches and scrapes on the surface of the Al connection material to form a smooth surface can be enhanced by controlling the orientation ratios of the crystal orientations of the Al phase and the Si phase in the L cross-section and adding the second element group thereto.

From a viewpoint of suppressing generation of scratches and scrapes on the surface to form the Al connection material having a smooth surface, a total concentration of the second element group in the Al connection material according to the present invention is more preferably equal to or larger than 20 mass ppm, even more preferably equal to or larger than 30 mass ppm, equal to or larger than 40 mass ppm, or equal to or larger than 50 mass ppm, and an upper limit thereof is preferably equal to or smaller than 450 mass ppm, and more preferably equal to or smaller than 440 mass ppm, equal to or smaller than 420 mass ppm, or equal to or smaller than 400 mass ppm.

As an aluminum raw material for manufacturing the Al connection material according to the present invention, it is preferable to use Al having a purity of 4N (Al: 99.99 mass% or more), and more preferable to use Al having a purity of 5N (Al: 99.999 mass% or more) in which an amount of impurities is smaller.

In a range of not inhibiting the effect of the present invention, the Al connection material according to the present invention may further contain elements other than Al, Si, the first element group, and the second element group (hereinafter, also referred to as "other elements"). A total concentration of the other elements in the Al connection

material is not particularly limited in a range of not inhibiting the effect of the present invention. The total concentration of the other elements may be, for example, equal to or smaller than 0.5 mass%, equal to or smaller than 0.4 mass%, equal to or smaller than 0.3 mass%, equal to or smaller than 0.2 mass%, equal to or smaller than 0.15 mass%, equal to or smaller than 0.1 mass%, equal to or smaller than 0.08 mass%, equal to or smaller than 0.06 mass%, equal to or smaller than 0.05 mass%, equal to or smaller than 0.04 mass%, equal to or smaller than 0.03 mass%, equal to or smaller than 0.025 mass%, equal to or smaller than 0.02 mass%, equal to or smaller than 0.018 mass%, equal to or smaller than 0.016 mass%, equal to or smaller than 0.015 mass%, equal to or smaller than 0.014 mass%, equal to or smaller than 0.012 mass%, or equal to or smaller than 0.01 mass%. A lower limit of the total concentration of the other elements is not particularly limited, and may be 0 mass%. According to one embodiment, a balance of the Al connection material according to the present invention consists of Al and the other elements. Thus, according to a preferred embodiment, the Al connection material according to the present invention consists of Al, Si, and the other elements. According to another preferred embodiment, the Al connection material according to the present invention consists of Al, Si, one or more elements of the first element group, and the other elements. According to yet another preferred embodiment, the Al connection material according to the present invention consists of Al, Si, one or more elements of the second element group, and the other elements. According to yet another preferred embodiment, the Al connection material according to the present invention consists of Al, Si, one or more elements of the first element group, one or more elements of the second element group, and the other elements.

According to one embodiment, a balance of the Al connection material according to the present invention consists of Al and inevitable impurities. Thus, according to a preferred embodiment, the Al connection material according to the present invention consists of Al, Si, and inevitable impurities. According to another preferred embodiment, the Al connection material according to the present invention consists of Al, Si, one or more elements of the first element group, and inevitable impurities. According to yet another preferred embodiment, the Al connection material according to the present invention consists of Al, Si, one or more elements of the second element group, and inevitable impurities. According to yet another preferred embodiment, the Al connection material according to the present invention consists of Al, Si, one or more elements of the first element group, one or more elements of the second element group, and inevitable impurities.

In a preferred embodiment, the Al connection material according to the present invention does not have a coating that contains a metal other than Al as a main component on an outer periphery of the Al connection material. Herein, the "coating that contains a metal other than Al as a main component" means the coating in which the content of the metal other than Al is 50 mass% or more.

The Al connection material according to the present invention may be an Al bonding wire or an Al bonding ribbon. In a case in which the Al connection material according to the present invention is the Al bonding wire, a wire diameter thereof is not particularly limited, and may fall within a range from 100 to 600 μm, for example. In a case in which the Al connection material according to the present invention is the Al bonding ribbon, dimensions (W×T) of a cross section having a rectangular shape or a substantially rectangular shape are not particularly limited, for example, W may be 100 to 3000 μm and T may be 50 to 600 μm.

The Al connection material according to the present invention can exhibit excellent temperature cycle reliability and favorable 1st bonding strength. Accordingly, the Al connection material according to the present invention can be preferably used as an Al connection material for a semiconductor device, especially as an Al connection material for a power semiconductor device.

-Method for manufacturing Al connection material-

The following describes an example of a method for manufacturing the Al connection material according to the present invention. The following describes an example of manufacture of an Al bonding wire having a wire diameter of 200 to 400 μm.

Al and alloy elements as raw materials preferably have a high purity. Al preferably has a purity of 99.99 mass% or more and includes inevitable impurities as a balance. Si, the first element group, and the second element group used as alloy elements preferably have a purity of 99.9 mass% or more and include inevitable impurities as a balance. An Al alloy used for the bonding wire can be manufactured by loading an Al raw material and raw materials for alloy elements into a crucible made of graphite or alumina that is processed to obtain an ingot having a cylindrical shape, and melting the raw materials by using an electric furnace or a high-frequency heating furnace. A diameter of the ingot having a cylindrical shape is preferably equal to or larger than Φ6 mm and smaller than Φ8 mm while considering processability at a subsequent processing step. An atmosphere in the furnace at the time of melting is preferably an inert atmosphere or a reducing atmosphere to prevent Al and/or other elements constituting the wire from being excessively oxidized. The highest end-point temperature of melted metal at the time of melting preferably falls within a range equal to or higher than 800°C and lower than 1050°C, considering to facilitate control of the shape and the size of the Si phase at the time of solidification and the like while securing fluidity of the melted metal. As a method for cooling after the melting, water cooling, furnace cooling, air cooling, and the like can be used.

By performing solution treatment to heat the ingot having a cylindrical shape obtained by melting at a high temperature, and repeatedly performing wire-drawing processing using dies thereon, the wire having a desired wire diameter can be manufactured. The wire after being subjected to the wire-drawing processing can be used as an Al alloy bonding wire by performing final heat treatment using the electric furnace.

To control the crystal orientation of the Si phase and the crystal orientation of the Al phase in the L cross-section, it is effective to control a heat treatment condition for solution treatment, homogenization processing, and final heat treatment, a wire-drawing processing condition, and the like. At the time of wire-drawing processing, it is effective to use a lubricating liquid to secure lubricity at a contact interface between the wire and the die.

The following describes an example of a manufacturing condition for controlling the <111>+<110> total ratio of the Al phase in the L cross-section to fall within a range equal to or larger than 20% and equal to or smaller than 70%, and controlling the <111>+<110> total ratio of the Si phase in the L cross-section to fall within a range equal to or larger than 20% and equal to or smaller than 70%.

To adjust the crystal orientation of the Si phase, it is effective to perform two-stage heat treatment on the ingot and to control an area reduction ratio of the wire-drawing processing.

It is effective to set a temperature range for the solution treatment to be equal to or higher than 400°C and lower than 550°C, and set a time therefor to be equal to or longer than 1 hour and shorter than 6 hours. After the solution treatment, it is effective to perform homogenization processing at a temperature equal to or higher than 250°C and lower than 350°C for a time equal to or longer than 2 hours and shorter than 6 hours. Accordingly, by accelerating fragmentation and growth of the Si phase crystallized in a solidification process, alignment of <111> and <110> of the crystal orientations of the Si phase can be promoted.

Regarding the wire-drawing processing condition, it is effective to set an area reduction ratio of the wire per die used at the time of wire-drawing processing to fall within a range equal to or larger than 10% and smaller than 20%. Herein, defining that the area reduction ratio of the wire per die is P1, P1 is represented by the following expression.

$$P1 = \{(R_2^2 - R_1^2)/R_2^2\} \times 100$$

In the expression, $R_2$ represents a diameter (mm) of the wire before processing, and $R_1$ represents a diameter (mm) of the wire after processing.

By adjusting the area reduction ratio of the wire in the range described above, the entire wire can be largely deformed at the time of die processing, processing distortion is increased to the inside of the wire, and the Si phase is arranged in the wire center axis direction while processing distortion in the Si phase is adjusted. By performing subsequent heat treatment from such a state of wire-drawing processing, the orientation ratios of the <111> crystal orientation and the <110> crystal orientation having high atomic density can be increased, and in the Si phase, the orientation ratios of the <111> crystal orientation and the <110> crystal orientation having a high elastic modulus can be increased.

To adjust the crystal orientations of the Al phase, it is effective to combine control of the area reduction ratio of the wire-drawing processing and control of a final heat treatment condition.

Specifically, processing distortion is controlled by adjusting a die area reduction ratio within a range equal to or larger than 10% and smaller than 20%, and ratios of the <111> crystal orientation and the <110> crystal orientation formed as a processed texture can be accelerated. For example, as the area reduction ratio increases, processing distortion tends to increase, and the ratios of the <111> crystal orientation and the <110> crystal orientation tend to increase.

As the final heat treatment condition, it is effective to set a temperature range to be equal to or higher than 200°C and lower than 360°C, and set a time within a range equal to or longer than 2 hours and shorter than 24 hours. By the final heat treatment, recovery and recrystallization of the Al phase proceed, and at the same time, an amount of Si dissolved in the Al phase as a solid solution is changed depending on a heat treatment temperature, whereby a recrystallization temperature is changed. By adjusting progress of recrystallization by the final heat treatment along with formation of the processed texture described above, alignment of crystal orientations can be easily controlled. For example, by adjusting the final heat treatment to a low temperature or a short time, orientation ratios of the <111> crystal orientation and the <110> crystal orientation having high density tend to increase.

To control the average diameter of the Al phase in the L cross-section to fall within a range equal to or larger than 5 μm and equal to or smaller than 40 μm, it is effective to adjust a temperature and a time for heat treatment applied to a wire having the final wire diameter, and control growth of the crystal grains due to recrystallization of the Al phase.

It is effective to control the temperature range for the final heat treatment to be equal to or higher than 250°C and lower than 340°C, and control the time to be equal to or longer than 5 hours and shorter than 24 hours. By adjusting a solid solution amount of Si contained in the Al phase by performing homogenization processing at a relatively low temperature, a recrystallization temperature of the Al phase can be easily adjusted in the final heat treatment, and the size of the Al phase can be controlled to fall within a desired range.

When intermediate heat treatment is performed as needed, the condition for the final heat treatment described above can be easily adjusted. The intermediate heat treatment is heat treatment that is performed in the intermediate of a step of processing the ingot until the final wire diameter is obtained. It is effective to set a temperature range for the intermediate heat treatment to be equal to or higher than 250°C and lower than 400°C, and set a time therefor to be equal to or longer than 30 minutes and shorter than 3 hours. It is effective that the intermediate heat treatment is performed with a wire diameter 2.5 to 4.0 times the final wire diameter. Processing distortion of the Al phase can be reduced and recrystallization can be advanced by performing the intermediate heat treatment. By primarily adjusting the Al phase, the particle diameter of the Al phase can be easily adjusted in the subsequent final heat treatment. For example, when the intermediate heat treatment temperature is increased, the diameter of the Al phase tends to be reduced.

To adjust the shape of the Si phase (shape ratio (e/f)) in the L cross-section, it is effective to control the two-stage heat treatment described above and the final heat treatment.

It is desirable that a temperature range for solution treatment of the ingot is set to be equal to or higher than 400°C and lower than 550°C, and a time therefor is set to be equal to or longer than 1 hour and shorter than 6 hours, and for subsequent homogenization processing, it is desirable that a temperature range is set to be equal to or higher than 250°C and lower than 350°C, and a time therefor is set to be equal to or longer than 2 hours and shorter than 6 hours. The solution treatment causes fragmentation and growth of the Si phase crystallized in the solidification process, and the homogenization processing causes dissolution and precipitation of Si at an interface of the Si phase, whereby the shape of the Si phase can be controlled. For example, when solution treatment is performed at a high temperature, the shape ratio (e/f) of the Si phase tends to be reduced.

As a representative example of the Al connection material, the example of manufacture of the Al bonding wire as a wire material has been described above. The Al bonding ribbon as a bar material can also be manufactured basically through the same procedure. As the temperature and the time for the heat treatment, substantially the same conditions as described above can be used. In a case of manufacturing the Al bonding ribbon by rolling processing, an area reduction ratio of a die may be replaced with a rolling reduction ratio to be adjusted.

[Semiconductor device]

The semiconductor device can be manufactured by connecting the electrode on the semiconductor chip to the lead frame or an external electrode on the substrate by using the Al connection material according to the present invention. As described above, wedge bonding is used for both of the 1st bonding with the electrode on the semiconductor chip and the 2nd bonding with the lead frame or the electrode on the substrate.

In one embodiment, the semiconductor device according to the present invention includes a circuit board, the semiconductor chip, and the Al connection material for bringing the circuit board and the semiconductor chip into conduction with each other, and is characterized in that the Al connection material is the Al connection material according to the present invention.

In the semiconductor device according to the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in Japanese Patent Application Laid-open No. 2020-150116, the semiconductor device may include a lead frame and a semiconductor chip mounted on the lead frame.

Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

[Examples]

Hereinafter, the present invention will be described in detail with reference to Examples. However, the present invention is not limited to the following Examples.

(Sample)

A method for producing a sample will be described. As a raw material, Al having a purity of 4N (99.99 mass% or more) and including inevitable impurities as a balance was used. Si, the first element group (Sr, Ca, Eu, Sb), and the second element group (Ni, Mg, Fe, In) used as alloy elements each having a purity of 99.99 mass% or more and including inevitable impurities as a balance were also used. The Al alloy used for the Al connection material was manufactured by loading an Al raw material and raw materials for the alloy elements into an alumina crucible, and melting them by using a high-frequency heating furnace. An atmosphere inside the furnace at the time of melting was an Ar atmosphere, and the

highest end-point temperature of melted metal at the time of melting was set to be equal to or higher than 800°C and lower than 1050°C. The cooling method after the melting was air cooling for performing cooling in the air, or water cooling for performing cooling in water.

After an ingot of Φ6 mm having a cylindrical shape was obtained by melting, and the ingot was subjected to solution treatment and homogenization processing, wire-drawing processing using dies and intermediate heat treatment were performed to produce an Al connection material (Al bonding wire) of Φ300 μm. A temperature range for the solution treatment was set to be equal to or higher than 500°C and lower than 550°C, and a time therefor was set to be equal to or longer than 2 hours and shorter than 4 hours. Homogenization processing was successively performed in the intermediate of cooling after the solution treatment was ended. A temperature range for the homogenization processing was set to be equal to or higher than 250°C and lower than 350°C, and a time therefor was set to be equal to or longer than 2 hours and shorter than 5 hours. The cooling method after the homogenization processing was air cooling for performing cooling in the air.

A commercially available lubricating liquid was used at the time of the wire-drawing processing, and an area reduction ratio of the wire per die at the time of the wire-drawing processing was equal to or larger than 12.5% and smaller than 16.0%. A temperature range for the final heat treatment was set to be equal to or higher than 250°C and lower than 360°C, and a time for the final heat treatment was set to be equal to or longer than 2 hours and shorter than 24 hours.

In some examples, the wire-drawing processing was performed using a die having a die angle equal to or larger than 14° and smaller than 18°.

(Method for measuring element content)

For concentration analysis of elements contained in the Al connection material, ICP-OES ("PS3520UVDDII" manufactured by Hitachi High-Tech Science Corporation) or ICP-MS ("Agilent 7700x ICP-MS" manufactured by Agilent Technologies, Inc.) was used as an analysis apparatus.

(Method for measuring orientation ratios of crystal orientations of Al phase and Si phase)

The L cross-section (cross section in the center axis direction including the center axis) of the Al connection material was designated as the inspection surface, and the crystal orientations of the Al phase and the Si phase were measured. In the present invention, the center axis of the Al connection material, and the cross section in the center axis direction including the center axis (L cross-section) are illustrated in FIG. 1. FIG. 1 illustrates a case in which the Al connection material is an Al bonding wire having a circular cross-sectional shape. In a case in which the Al connection material is an Al bonding ribbon having a rectangular or substantially rectangular cross-sectional shape with a width W and a thickness T, the center axis indicates an axis passing through the center of the width W and the center of the thickness T, and the L cross-section indicates a cross section in the center axis direction including the center axis and in a direction of the thickness T. At the time of processing the cross section to expose the L cross-section of the Al connection material, the cross section may be deviated from the center axis of the Al connection material. At this point, if the length of the L cross-section in the direction perpendicular to the center axis is 90% or more of the wire diameter of the Al connection material (or the thickness T in a case of the ribbon), the cross-section can be regarded as a cross section including the center axis.

An FE-SEM (SU-70 manufactured by Hitachi High-Tech Corporation) was used for measurement, and APEX (for data collection) manufactured by TSL solutions KK, OIM Data Collection (for Chi Scan), and OIM Analysis (for data analysis) were used as analysis software. Measurement regions at three parts were randomly selected at intervals of 50 cm or more with respect to the center axis direction of the Al connection material, and the regions at the three parts were measured. The measurement region was determined so that the length in the center axis direction of the Al connection material was equal to or larger than 300 μm and smaller than 800 μm, and the entire Al connection material was accommodated in the direction perpendicular to the center axis. As a main condition for EDS and EBSD measurement, an acceleration voltage was set to be 15 kV, a measurement magnification was set to be 350-fold, a scan speed was set to be 30 to 120 points/second, and a measurement interval was set to fall within a range from 0.1 to 0.3 μm. Herein, if the scan speed is high, the measurement time can be shortened, but there is concern that measurement accuracy of the EDS may be lowered. It is preferable to select an appropriate scan speed in the range described above.

-Crystal orientation of Al phase-

In measuring the orientation ratios of the crystal orientations of the Al phase in the L cross-section of the Al connection material, a method of combining information of Al concentration and Si concentration obtained by the SEM-EDS and information of a crystal orientation obtained by the EBSD was used. Specifically, measurement was performed in accordance with procedures from (1) to (3) as follows.

(1) In the measurement region designating the L cross-section of the Al connection material to be the inspection surface, measurement of concentration of Al and Si using the EDS and crystal orientation measurement using the EBSD were performed at the same time.
(2) Al and Si were separated and extracted by using the Chi Scan function as a function of EBSD analysis software. Specifically, Al and Si were separated and identified by setting Tolerance corresponding to a threshold of Si based on a measurement result of the EDS for Si. The crystal information of Al and Si from the material file was used for analyzing the crystal orientation. Herein, a condition for Tolerance was mainly set to be 30%, and adjusted as needed.
(3) For a region specified as the Al phase, the crystal orientations were analyzed, and the orientation ratio of the <111> crystal orientation and the orientation ratio of the <110> crystal orientation of the Al phase were calculated. As crystal orientations to be investigated, at least three types of <111>, <110>, and <100>, which are representative crystal orientations of Al metal, and crystal orientations having high ratios were selected as needed. Herein, as the orientation ratio of the crystal orientation, a partial ratio was used.

The orientation ratio of the <111> crystal orientation and the orientation ratio of the <110> crystal orientation of the Al phase were calculated as average values of respective values obtained for measurement regions at three parts through the procedures from (1) to (3) described above.

-Crystal orientation of Si phase-

In measuring the orientation ratios of the crystal orientations of the Si phase in the L cross-section of the Al connection material, similarly to measurement of the orientation ratios of the crystal orientations of the Al phase, a method of combining information of Al concentration and Si concentration obtained by the SEM-EDS and information of a crystal orientation obtained by the EBSD was used. Specifically, after performing the procedures (1) and (2) described above, measurement was performed through the procedure (3) as follows.
(3) For a region specified as the Si phase, the crystal orientations were analyzed, and the orientation ratio of the <110> crystal orientation and the orientation ratio of the <110> crystal orientation of the Si phase were calculated. As the orientation ratio of the crystal orientation, a partial ratio was used.
The orientation ratio of the <111> crystal orientation and the orientation ratio of the <110> crystal orientation of the Si phase were calculated as average values of respective values obtained for measurement regions at three parts through the procedures from (1) to (3) described above.

(Method for measuring average diameter of Al phase)

In measuring the average diameter of the Al phase in the L cross-section of the Al connection material, similarly to measurement of the orientation ratios of the crystal orientations of the Al phase, a method of combining information of Al concentration and Si concentration obtained by the SEM-EDS and information of a crystal orientation obtained by the EBSD was used. Specifically, after performing the procedures (1) and (2) described above, measurement was performed through the procedure (3) as follows.
(3) For the region that is specified as the Al phase, the crystal orientation was analyzed, and if the orientation difference between measurement points was equal to or larger than 15°, it was determined to be the crystal grain boundary, and the equivalent circle diameter of each crystal grain was obtained. An average of equivalent circle diameters of the respective crystal grains was calculated to obtain the average diameter of the Al phase. Herein, regarding average calculation, an average value obtained by Area average, which can be selected by the software attached to the apparatus, was used. In calculating the average diameter of the Al phase in the L cross-section, only Al phases having a diameter (equivalent circle diameter) equal to or larger than 0.5 μm were considered as targets.
The average diameter of the Al phase was calculated as an average value of respective values obtained for measurement regions at three parts through the procedures from (1) to (3) described above.

(Method for measuring shape of Si phase)

In measuring the shape of the Si phase (shape ratio (e/f)) in the L cross-section of the Al connection material, similarly to measurement of the orientation ratios of the crystal orientations of the Al phase, a method of combining information of Al concentration and Si concentration obtained by the SEM-EDS and information of a crystal orientation obtained by the EBSD was used. Specifically, after performing the procedures (1) and (2) described above, measurement was performed through the procedure (3) as follows.
(3) For the region that is specified as the Si phase, the crystal orientation was analyzed, and if the orientation difference between measurement points was equal to or larger than 15°, it was determined to be the crystal grain boundary, and the shape ratio (e/f) of each crystal grain was obtained. An average of the shape ratios (e/f) of the respective crystal grains was

calculated to obtain the average value of the shape ratio (e/f) of the Si phase. Herein, as the average value of the shape ratio (e/f) of the Si phase, a numerical value of Grain Shape Aspect Ratio of the analysis software ("grain shape aspect ratio") was used. Regarding the method for calculating the grain shape aspect ratio, the ratio (e/f) between the short side length (e) (Grain Shape Minor Axis) and the long side length (f) (Grain Shape Major Axis) of one crystal grain is automatically calculated by software. Regarding average calculation, an average value obtained by Area average was used.

(Method for evaluating Al connection material)

The following describes a method for evaluating the Al connection material. The wire diameter of the Al connection material (Al bonding wire) used for evaluation was Φ300 μm. The semiconductor chip made of Si was used, and as the electrode on the semiconductor chip, used was an alloy having a composition of Al-0.5%Cu deposited to have a thickness of 4 μm. As a substrate, 5 μm of Ni was deposited on an Al alloy. For bonding of the Al connection material, a commercially available wire bonder (manufactured by ULTRASONIC ENGINEERING CO., LTD.) was used, and wedge bonding was used for both of the 1st bonding and the 2nd bonding.

(Method for evaluating temperature cycle reliability)

For evaluation of the temperature cycle test, a commercially available thermal shock test apparatus was used. In the temperature cycle test, a temperature rise and a temperature fall are repeated as a sample chamber moves between a low-temperature tank and a high-temperature tank. A temperature of the low-temperature tank was set to be -40°C, and a temperature of the high-temperature tank was set to be 175°C. The test was started in a state in which the sample chamber was present in the high-temperature tank, and a period from the time when the sample chamber moved to the low-temperature tank until it returned to the high-temperature tank was defined as one cycle. A time during which the sample chamber stayed in each of the low-temperature tank and the high-temperature tank was set to be 20 minutes. A sample to be subjected to the temperature cycle test had a structure in which a semiconductor chip was mounted on a substrate, and an electrode on the semiconductor chip was connected with an electrode on the substrate via the Al connection material. After the test was started, the sample was taken out every 250 cycles, and a shear test was performed on the 1st bonding part. As a value of shear force of the 1st bonding part used for evaluating the temperature cycle reliability, an average value of shear force of 1st bonding parts at five points, which were randomly extracted, was used. The number of cycles at the time when the shear force was lowered to be 70% or less of a value before the temperature cycle test was defined as a lifetime of the bonding part. If the lifetime of the bonding part was smaller than 500 cycles, it was determined that there was a problem in a practical use and evaluated as "0". If the lifetime of the bonding part was equal to or larger than 500 cycles and smaller than 750 cycles, it was determined that there was no problem in a practical use and evaluated as "1". If the lifetime of the bonding part was equal to or larger than 750 cycles and smaller than 1000 cycles, it was determined to be excellent and evaluated as "2". If the lifetime of the bonding part was equal to or larger than 1000 cycles, it was determined to be especially excellent and evaluated as "3". "0" is unacceptable, and "1", "2", and "3" are acceptable. Evaluation results are described in a column of "Temperature cycle reliability" in tables.

(Method for evaluating variation in bonding strength in temperature cycle test)

In the temperature cycle test described above, shear force was measured for 1st bonding parts at twenty parts after 1400 cycles of the test. In evaluating variation in bonding strength in the temperature cycle test, a population standard deviation (σ) of shear force was calculated. If σ was smaller than 30 gf, it was determined that variation in bonding strength was particularly small and stability was excellent, and evaluated as "3". If σ was equal to or larger than 30 gf and smaller than 50 gf, it was determined that variation in bonding strength was small and stability was excellent, and evaluated as "2". If σ was equal to or larger than 50 gf and smaller than 70 gf, it was determined that variation in bonding strength fell within a permissible range and stability was favorable, and evaluated as "1". If σ was equal to or larger than 70 gf, it was determined that variation in bonding strength was large and there was a problem in a practical use, and described as "0". As another viewpoint different from the population standard deviation, in a case in which an average value of the shear force was lowered to 70% or less of a value before the temperature cycle test, it was determined that a lifetime had been exceeded, and described as "0". "0" is unacceptable, and "1", "2", and "3" are acceptable. Evaluation results are described in a column of "Temperature cycle reliability/variation in bonding strength (1400 times)" in the tables.

(Method for evaluating 1st bonding strength)

The following describes a method for evaluating the 1st bonding strength. The 1st bonding strength was evaluated by a shear force test. The 1st bonding was performed at ten parts under a general bonding condition, and the

shear force of the 1st bonding part was measured. For measurement of the shear force, a commercially available micro shear force tester (4000-PLUS manufactured by Nordson Corporation) was used. A shear rate was set to be 200 μm/sec, and a height of a shearing tool was set to be 10 μm from an electrode surface. The shear force was measured by fixing, with a jig, a substrate to which the Al connection material was bonded. If an average value of the shear force of the 1st bonding parts at ten parts was equal to or larger than 1400 gf, it was determined to be excellent and evaluated as "3". If the average value was equal to or larger than 1200 gf and smaller than 1400 gf, it was determined that there was no problem in a practical use and evaluated as "2". If the average value was equal to or larger than 1000 gf and smaller than 1200 gf, it was determined that improvement was required and evaluated as "1". If the average value was smaller than 1000 gf, it was determined that there was a problem in a practical use and evaluated as "0". Evaluation results are described in a column of "1st bonding strength" in the tables.

(Method for evaluating hollow at 1st bonding part)

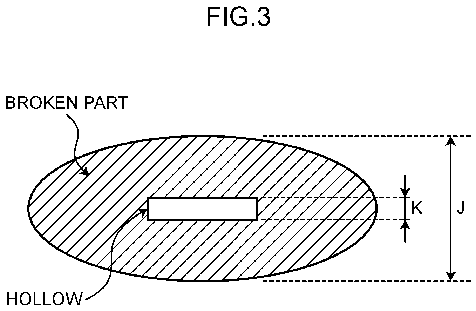

The following describes a method for evaluating a hollow defect at the 1st bonding part. After performing the shear force test on the 1st bonding part described above, an impression on a broken surface on the electrode side was observed by an optical microscope or an SEM, and a part where metallic bonding is not achieved in a broken region was determined to be a hollow. The part where the hollow is generated is a part that is not bonded even when the electrode is deformed, and can be discriminated from a region in which metallic bonding is achieved. The shear force test was performed under the condition described above, and broken surfaces at ten parts of the 1st bonding part were observed. A ratio of a total length (K) of a hollow region in a bonding width direction to a bonding length (J) in the vertical direction (bonding width direction) with respect to the center axis of the Al connection material was obtained as a hollow ratio (K/J) (FIG. 3). Hollow ratios are checked for broken surfaces at ten parts, and a maximum value thereof is defined as a "hollow defect rate". If the hollow defect rate was smaller than 5%, it was determined to be favorable and evaluated as "3". If the hollow defect rate was equal to or larger than 5% and smaller than 15%, it was determined that there was no problem in a practical use and evaluated as "2". If the hollow defect rate was equal to or larger than 15% and smaller than 25%, it was determined that improvement was required and evaluated as "1". If the hollow defect rate exceeded 25%, it was determined to be an obstruction to mass production and evaluated as "0". Evaluation results are described in a column of "Hollow at 1st bonding part" in the tables.

(Method for evaluating bonding strength stability of 2nd bonding part)

The shear force test was performed on 2nd bonding parts at thirty points, which were randomly selected, to acquire the bonding strength, and a population standard deviation ($\sigma$) was calculated. If $\sigma$ was equal to or larger than 70 gf, it was determined that there was a problem in a practical use and evaluated as "0". If $\sigma$ was equal to or larger than 50 gf and smaller than 70 gf, it was determined to be favorable and evaluated as "1". If $\sigma$ was equal to or larger than 30 gf and smaller than 50 gf, it was determined to be excellent and evaluated as "2". If $\sigma$ was smaller than 30 gf, it was determined to be especially excellent and evaluated as "3". "0" is unacceptable, and "1", "2", and "3" are acceptable. Evaluation results are described in a column of "Bonding strength stability of 2nd bonding part" in the tables.

(Method for evaluating wire breakage during processing)

The following describes a method for evaluating wire breakage during processing. Wire-drawing processing was performed from a wire diameter of 6 mmφ to a wire diameter of 0.3 mmφ, and the number of times of wire breakage was checked. A feeding speed, the area reduction ratio, and the like as processing conditions for wire-drawing are selected from the conditions described above, and appropriate manufacturing conditions are adjusted or changed for each wire. The length of the drawn Al connection material fell within a range from 100 to 200 m, and the number of times of wire breakage was calculated in terms of 100 m. If the number of times of wire breakage was 0, it was determined to be favorable and evaluated as "3". If the number of times of wire breakage was 1, it was determined to be able to be handled by improving the manufacturing condition and evaluated as "2". If the number of times of wire breakage was 2 to 4, lowering of productivity was regarded as a problem and evaluated as "1". If the number of times of wire breakage was 5 or more, it was determined that a practical use was difficult to be achieved and evaluated as "0". Evaluation results are described in a column of "Wire breakage during processing" in the tables.

(Method for evaluating scratch and scrape on surface)

A surface property of the Al connection material is evaluated focusing on scratches and scrapes. The wire diameter of the Al connection material was set to be 0.3 mmφ. Measurement regions at three parts were randomly selected at intervals of 1 m or more with respect to the center axis direction of the Al connection material, and three samples each

having a length of about 2 cm were taken at each of the three parts to observe nine samples in total. The surface was observed with magnification in a range from 50-fold to 500-fold of the SEM. A scratch having a length equal to or larger than 50 μm and a scrape having a length equal to or larger than 30 μm were determined to be defects. Parts of scratches and scrapes were counted. If the number thereof was 0, it was determined to be favorable and acceptable, and evaluated as "3". If the number thereof was equal to or smaller than 2, it was determined that there was no problem in a practical use and evaluated as "2". If the number thereof was 3 to 7, it was determined that the surface property was not good, and evaluated as "1". If the number thereof was 8 or more, it was determined that a practical use was difficult to be achieved and evaluated as "0". Evaluation results are described in a column of "Surface property" in the tables.

The evaluation results of Examples and Comparative Examples are indicated in Table 1 to Table 3.

[Table 1]

(Table 1)

| | No. | Contained element and concentration | | | | | | | | | | | | <111>+<110> total ratio of Al phase (%) | <110> ratio of Al phase (%) | <111>+<110> total ratio of Si phase (%) | Average diameter of Al phase (μm) | Shape of Si phase (e/f) | Evaluation result | | | | | | |
|---|---|---|---|---|---|---|---|---|---|---|---|---|---|---|---|---|---|---|---|---|---|---|---|---|---|
| | | Si (mass%) | Sr (mass ppm) | Ca (mass ppm) | Eu (mass ppm) | Sb (mass ppm) | Ni (mass ppm) | Mg (mass ppm) | Fe (mass ppm) | In (mass ppm) | Other elements (mass ppm) | Total of first element group (mass ppm) | Total of second element group (mass ppm) | | | | | | Temperature cycle reliability | Temperature cycle reliability, variation in bonding strength (1400 times) | 1st bonding strength | Hollow at 1st bonding part | Bonding strength stability of 2nd bonding part | Wire breakage during processing | Surface property |
| Example | 1 | 3.0 | | | | | | | | | | 0 | 0 | 33 | 15 | 41 | 24.2 | 0.48 | 2 | 3 | 2 | 3 | 3 | 2 | 2 |
| | 2 | 3.5 | | | | | | | | | | 0 | 0 | 41 | 17 | 36 | 42.2 | 0.38 | 2 | 3 | 3 | 3 | 1 | 2 | 2 |
| | 3 | 4.0 | | | | | | | | | | 0 | 0 | 54 | 32 | 23 | 21.8 | 0.73 | 3 | 2 | 3 | 3 | 3 | 2 | 2 |
| | 4 | 4.0 | | | | | | | | | | 0 | 0 | 42 | 20 | 32 | 34.2 | 0.43 | 3 | 3 | 3 | 3 | 3 | 2 | 2 |
| | 5 | 4.2 | | | | | | | | | | 0 | 0 | 44 | 3 | 20 | 32.5 | 0.68 | 2 | 3 | 2 | 2 | 3 | 2 | 2 |
| | 6 | 4.6 | | | | | | | | | | 0 | 0 | 59 | 25 | 25 | 22.5 | 0.63 | 3 | 3 | 3 | 3 | 3 | 2 | 2 |
| | 7 | 4.8 | | | | | | | | | | 0 | 0 | 20 | 11 | 35 | 18.6 | 0.58 | 3 | 3 | 3 | 3 | 3 | 2 | 2 |
| | 8 | 5.0 | | | | | | | | | | 0 | 0 | 30 | 5 | 58 | 21.2 | 0.36 | 3 | 3 | 2 | 3 | 3 | 2 | 2 |
| | 9 | 5.4 | | | | | | | | | | 0 | 0 | 40 | 18 | 34 | 18.0 | 0.34 | 3 | 3 | 3 | 3 | 3 | 2 | 2 |
| | 10 | 6.0 | | | | | | | | | | 0 | 0 | 43 | 12 | 31 | 32.6 | 0.71 | 3 | 2 | 3 | 3 | 3 | 2 | 2 |
| | 11 | 7.8 | | | | | | | | | | 0 | 0 | 46 | 23 | 35 | 13.5 | 0.45 | 3 | 3 | 3 | 3 | 3 | 2 | 2 |
| | 12 | 6.0 | | | | | | | | | | 0 | 0 | 51 | 15 | 22 | 18.3 | 0.31 | 2 | 3 | 3 | 3 | 3 | 2 | 2 |
| | 13 | 7.0 | | | | | | | | | | 0 | 0 | 37 | 13 | 29 | 26.2 | 0.30 | 3 | 3 | 3 | 3 | 3 | 2 | 2 |
| | 14 | 7.3 | | | | | | | | | | 0 | 0 | 32 | 2 | 30 | 31.5 | 0.68 | 3 | 3 | 2 | 2 | 2 | 2 | 2 |
| | 15 | 6.5 | | | | | | | | | | 0 | 0 | 56 | 32 | 56 | 23.0 | 0.63 | 3 | 3 | 3 | 3 | 3 | 2 | 2 |
| | 16 | 6.8 | | | | | | | | | | 0 | 0 | 44 | 25 | 23 | 15.6 | 0.67 | 2 | 3 | 3 | 3 | 3 | 2 | 2 |
| | 17 | 6.9 | | | | | | | | | | 0 | 0 | 27 | 4 | 28 | 17.2 | 0.52 | 3 | 2 | 3 | 2 | 3 | 2 | 2 |
| | 18 | 7.0 | | | | | | | | | | 0 | 0 | 51 | 18 | 31 | 16.7 | 0.32 | 3 | 3 | 3 | 3 | 3 | 2 | 2 |
| | 19 | 7.0 | | | | | | | | | | 0 | 0 | 53 | 28 | 33 | 11.6 | 0.38 | 3 | 3 | 3 | 3 | 3 | 2 | 2 |
| | 20 | 7.0 | | | | | | | | | | 0 | 0 | 45 | 17 | 32 | 14.4 | 0.43 | 3 | 3 | 3 | 3 | 3 | 2 | 2 |
| | 21 | 7.2 | | | | | | | | | | 0 | 0 | 47 | 15 | 38 | 30.4 | 0.37 | 3 | 3 | 3 | 3 | 2 | 2 | 2 |
| | 22 | 7.4 | | | | | | | | | | 0 | 0 | 48 | 28 | 63 | 18.2 | 0.19 | 3 | 1 | 3 | 3 | 3 | 2 | 2 |
| | 23 | 7.5 | | | | | | | | | | 0 | 0 | 21 | 12 | 22 | 13.9 | 0.38 | 2 | 2 | 3 | 3 | 3 | 2 | 2 |
| | 24 | 8.4 | | | | | | | | | | 0 | 0 | 70 | 41 | 42 | 4.8 | 0.38 | 3 | 3 | 2 | 2 | 2 | 2 | 2 |
| | 25 | 8.6 | | | | | | | | | | 0 | 0 | 42 | 17 | 70 | 15.0 | 0.24 | 2 | 3 | 3 | 3 | 3 | 2 | 2 |
| | 26 | 9.0 | | | | | | | | | | 0 | 0 | 41 | 20 | 49 | 13.8 | 0.43 | 3 | 3 | 3 | 3 | 3 | 2 | 2 |
| | 27 | 9.5 | | | | | | | | | | 0 | 0 | 45 | 15 | 60 | 13.2 | 0.28 | 3 | 3 | 3 | 3 | 3 | 2 | 2 |
| | 28 | 10.0 | | | | | | | | | | 0 | 0 | 57 | 23 | 37 | 3.4 | 0.59 | 3 | 3 | 3 | 3 | 2 | 2 | 2 |
| | 29 | 10.8 | | | | | | | | | | 0 | 0 | 49 | 31 | 59 | 8.3 | 0.18 | 3 | 1 | 3 | 3 | 3 | 2 | 2 |
| | 30 | 11.1 | | | | | | | | | | 0 | 0 | 58 | 20 | 65 | 6.2 | 0.27 | 2 | 3 | 3 | 3 | 3 | 2 | 2 |
| | 31 | 12.0 | | | | | | | | | | 0 | 0 | 55 | 22 | 60 | 7.3 | 0.25 | 2 | 3 | 3 | 3 | 3 | 2 | 2 |

[Table 2]

(Tanle 2)

| | No. | Contained element and concentration | | | | | | | | | | | | | | | | | Evaluation result | | | | | | |
|---|---|---|---|---|---|---|---|---|---|---|---|---|---|---|---|---|---|---|---|---|---|---|---|---|---|
| | | Si (mass%) | Sr (mass ppm) | Ca (mass ppm) | Eu (mass ppm) | Sb (mass ppm) | Ni (mass ppm) | Mg (mass ppm) | Fe (mass ppm) | In (mass ppm) | Other elements (mass ppm) | Total of first element group (mass ppm) | Total of second element group (mass ppm) | <111>+<110> total ratio of Al phase (%) | <110> ratio of Al phase (%) | <111>+<110> total ratio of Si phase (%) | Average diameter of Al phase (μm) | Shape of Si phase (e/f) | Temperature cycle reliability | Temperature cycle reliability, variation in bonding strength (1400 times) | 1st bonding strength | Hollow at 1st bonding part | Bonding strength stability of 2nd bonding part | Wire breakage during processing | Surface property |
| Example | 32 | 5.0 | 10 | | | | | | | | | 10 | 0 | 49 | 13 | 54 | 30.7 | 0.37 | 3 | 3 | 3 | 3 | 2 | 3 | 2 |
| | 33 | 6.7 | 50 | | | | | | | | | 50 | 0 | 27 | 4 | 38 | 16.7 | 0.43 | 3 | 2 | 3 | 2 | 3 | 3 | 2 |
| | 34 | 7.0 | 150 | | | | | | | | | 150 | 0 | 46 | 33 | 43 | 26.2 | 0.45 | 3 | 3 | 3 | 3 | 3 | 3 | 2 |
| | 35 | 7.9 | 250 | | | | | | | | | 250 | 0 | 20 | 14 | 52 | 18.8 | 0.36 | 3 | 2 | 3 | 3 | 3 | 3 | 2 |
| | 36 | 6.6 | 780 | | | | | | | | | 780 | 0 | 35 | 10 | 23 | 18.2 | 0.72 | 2 | 2 | 2 | 2 | 3 | 3 | 2 |
| | 37 | 8.0 | | 300 | | | | | | | | 300 | 0 | 57 | 23 | 54 | 24.4 | 0.32 | 3 | 3 | 3 | 3 | 3 | 3 | 2 |
| | 38 | 5.5 | | | 60 | | | | | | | 60 | 0 | 48 | 35 | 43 | 24.7 | 0.36 | 3 | 3 | 3 | 3 | 3 | 3 | 2 |
| | 39 | 7.0 | | | 600 | | | | | | | 600 | 0 | 51 | 22 | 39 | 23.8 | 0.53 | 3 | 3 | 3 | 3 | 3 | 3 | 2 |
| | 40 | 9.0 | | | | 80 | | | | | | 80 | 0 | 64 | 50 | 48 | 31.2 | 0.31 | 3 | 3 | 2 | 2 | 2 | 3 | 2 |
| | 41 | 6.0 | 100 | | 200 | | | | | | | 300 | 0 | 56 | 24 | 46 | 24.8 | 0.42 | 3 | 3 | 3 | 3 | 3 | 3 | 2 |
| | 42 | 11.0 | 350 | 350 | | | | | | | | 700 | 0 | 48 | 23 | 61 | 23.5 | 0.45 | 2 | 3 | 3 | 3 | 3 | 3 | 2 |
| | 43 | 9.5 | 300 | 100 | 300 | 100 | | | | | Ti: 105 | 800 | 0 | 45 | 14 | 34 | 19.3 | 0.43 | 3 | 3 | 3 | 3 | 3 | 3 | 2 |
| | 44 | 6.0 | | 350 | 400 | 100 | | | | | | 850 | 0 | 56 | 21 | 31 | 13.7 | 0.53 | 3 | 3 | 3 | 3 | 3 | 2 | 2 |
| | 45 | 6.0 | | | | | 50 | | | | | 0 | 50 | 48 | 33 | 34 | 27.2 | 0.29 | 3 | 3 | 3 | 3 | 3 | 2 | 3 |
| | 46 | 8.5 | | | | | | 200 | | | | 0 | 200 | 50 | 33 | 57 | 16.3 | 0.34 | 3 | 3 | 3 | 3 | 3 | 2 | 3 |
| | 47 | 6.0 | | | | | | | 10 | | | 0 | 10 | 45 | 25 | 44 | 26.6 | 0.36 | 3 | 3 | 3 | 3 | 3 | 2 | 3 |
| | 48 | 4.8 | | | | | | | | 100 | | 0 | 100 | 41 | 14 | 32 | 43.2 | 0.30 | 3 | 3 | 3 | 3 | 1 | 2 | 3 |
| | 49 | 6.5 | | | | | 100 | 100 | 100 | | | 0 | 300 | 34 | 8 | 45 | 23.5 | 0.32 | 3 | 3 | 3 | 3 | 3 | 2 | 3 |
| | 50 | 6.0 | | | | | | 300 | | 200 | | 0 | 500 | 41 | 4 | 41 | 22.4 | 0.33 | 3 | 3 | 2 | 2 | 3 | 2 | 3 |
| | 51 | 8.0 | | | | | 200 | 200 | 200 | | | 0 | 600 | 60 | 30 | 62 | 4.4 | 0.31 | 2 | 3 | 3 | 3 | 2 | 2 | 2 |
| | 52 | 7.5 | | | 8 | | 50 | | | | | 8 | 50 | 52 | 28 | 52 | 21.5 | 0.33 | 3 | 3 | 3 | 3 | 3 | 2 | 3 |
| | 53 | 7.8 | 150 | | | | | 30 | 15 | | | 150 | 45 | 26 | 3 | 44 | 18.2 | 0.42 | 3 | 2 | 3 | 2 | 3 | 3 | 3 |
| | 54 | 10.2 | 100 | | | | | 100 | | | | 100 | 100 | 50 | 12 | 48 | 25.7 | 0.37 | 3 | 3 | 3 | 3 | 3 | 3 | 3 |
| | 55 | 5.5 | | | 125 | | 40 | 30 | | | Sn: 55 | 125 | 70 | 22 | 12 | 48 | 25.7 | 0.37 | 3 | 3 | 3 | 3 | 3 | 3 | 3 |
| | 56 | 6.0 | | 200 | 200 | | | | 50 | 150 | | 400 | 200 | 38 | 8 | 43 | 21.4 | 0.38 | 3 | 3 | 3 | 3 | 3 | 3 | 3 |
| | 57 | 9.0 | 400 | | | 100 | 50 | 200 | 100 | | | 500 | 350 | 47 | 15 | 34 | 16.3 | 0.40 | 3 | 3 | 3 | 3 | 3 | 3 | 3 |
| | 58 | 6.0 | 100 | | 400 | 100 | | 150 | | 100 | | 600 | 250 | 43 | 18 | 46 | 15.6 | 0.45 | 3 | 3 | 3 | 3 | 3 | 3 | 3 |

[Table 3]

(Table 3)

| | No. | Contained element and concentration | | | | | | | | | | | | <111>+<110> total ratio of Al phase (%) | <110> ratio of Al phase (%) | <111>+<110> total ratio of Si phase (%) | Average diameter of Al phase (μm) | Shape of Si phase (e/f) | Evaluation result | | | | | | |
|---|---|---|---|---|---|---|---|---|---|---|---|---|---|---|---|---|---|---|---|---|---|---|---|---|---|
| | | Si (mass%) | Sr (mass ppm) | Ca (mass ppm) | Eu (mass ppm) | Sb (mass ppm) | Ni (mass ppm) | Mg (mass ppm) | Fe (mass ppm) | In (mass ppm) | Other elements (mass ppm) | Total of first element group (mass ppm) | Total of second element group (mass ppm) | | | | | | Temperature cycle reliability | Temperature cycle reliability, variation in bonding strength (1400 times) | 1st bonding strength | Hollow at 1st bonding part | Bonding strength stability of 2nd bonding part | Wire breakage during processing | Surface property |
| Comparative example | 1 | 0.0 | | | | | | | | | | 0 | 0 | 23 | 2 | – | 32.5 | – | 0 | 0 | 0 | 2 | 1 | 2 | 2 |
| | 2 | 2.5 | | | | | | | | | | 0 | 0 | 34 | 8 | 32 | 27.2 | 0.56 | 0 | 0 | 0 | 1 | 1 | 2 | 1 |
| | 3 | 12.5 | | | | | | | | | | 0 | 0 | 52 | 21 | 56 | 7.5 | 0.27 | 1 | 0 | 0 | 2 | 0 | 0 | 0 |
| | 4 | 5.5 | | | | | | | | | | 0 | 0 | 25 | 4 | 35 | 20.2 | 0.56 | 1 | 1 | 0 | 1 | 0 | 1 | 0 |
| | 5 | 4.4 | | | | | | | | | | 0 | 0 | 21 | 3 | 32 | 14.5 | 0.67 | 1 | 0 | 0 | 1 | 0 | 0 | 0 |
| | 6 | 6.8 | | | | | | | | | | 0 | 0 | 19 | 8 | 24 | 28.4 | 0.46 | 1 | 0 | 0 | 1 | 0 | 0 | 0 |
| | 7 | 8.2 | | 200 | | | | 150 | | | | 200 | 150 | 17 | 4 | 52 | 20.2 | 0.67 | 0 | 0 | 0 | 1 | 0 | 1 | 0 |
| | 8 | 6.0 | | | | | | | | | | 0 | 0 | 74 | 32 | 53 | 12.7 | 0.30 | 1 | 1 | 0 | 2 | 0 | 1 | 0 |
| | 9 | 6.0 | | | | | | | | | | 0 | 0 | 42 | 14 | 18 | 18.7 | 0.45 | 0 | 0 | 1 | 2 | 1 | 1 | 0 |
| | 10 | 5.0 | | | | | | | | | | 0 | 0 | 57 | 33 | 73 | 16.3 | 0.25 | 0 | 0 | 0 | 2 | 1 | 1 | 0 |

It was confirmed that all Al connection materials of Examples Nos. 1 to 58 contained 3.0 mass% or more and 12.0

mass% or less of Si, the <111>+<110> total ratio of the Al phase in the L cross-section thereof was equal to or larger than 20% and equal to or smaller than 70% (provided that, when the total of the orientation ratios was equal to or smaller than 25%, an orientation ratio of the <110> crystal orientation angled at 15° or less to the center axis direction was equal to or larger than 5%), the <111>+<110> total ratio of the Si phase in the L cross-section thereof was equal to or larger than 20% and equal to or smaller than 70%, and excellent temperature cycle reliability and favorable 1st bonding strength were exhibited.

Additionally, it was confirmed that, with the Al connection materials in Examples Nos. 1 to 4, 6 to 13, 15, 16, 18 to 23, 25 to 32, 34 to 39, 41 to 49, 51, 52, and 54 to 58 in which the <110> ratio of the Al phase in the L cross-section was equal to or larger than 5% and equal to or smaller than 40%, a more favorable result was obtained regarding the 1st bonding strength and a hollow at the 1st bonding part could be suppressed.

It was also confirmed that, with the Al connection materials in Examples Nos. 1, 3 to 23, 25 to 27, 29 to 47, 49, 50, and 52 to 58 in which the average diameter of the Al phase in the L cross-section was equal to or larger than 5 μm and equal to or smaller than 40 μm, a more favorable result was easily obtained regarding the bonding strength stability of the 2nd bonding part.

It was confirmed that the Al connection materials in Examples Nos. 1, 2, 4 to 9, 11 to 21, 23 to 28, 30 to 35, and 37 to 58, in which an average value of the shape ratio (e/f) of the Si phase in the L cross-section was equal to or larger than 0.2 and equal to or smaller than 0.7, tended to reduce variation in bonding strength in the temperature cycle test.

Furthermore, it was confirmed that, with the Al connection materials of Examples Nos. 32 to 43 and 53 to 58 containing 10 mass ppm or more and 800 mass ppm or less of one or more elements of the first element group (Sr, Ca, Eu, Sb) in total, a generation frequency of wire breakage during processing could be reduced.

It was also confirmed that, with the Al connection materials in Examples Nos. 45 to 50 and 52 to 58 containing 10 mass ppm or more and 500 mass ppm or less of one or more elements of the second element group (Ni, Mg, Fe, In) in total, generation of scratches and scrapes on the surface was suppressed and a smooth surface was obtained.

On the other hand, it was confirmed that the Al connection materials of Comparative Examples Nos. 1 to 10 were outside the scope of the present invention in any one of the Si concentration, the <111>+<110> total ratio of the Al phase in the L cross-section (including the <110> ratio of the Al phase in a case in which the total ratio was equal to or larger than 20% and equal to or smaller than 25%), and the <111>+<110> total ratio of the Si phase in the L cross-section (including the <110> ratio of the Al phase in a case in which the total ratio was equal to or smaller than 25%), and that any one of temperature cycle reliability and 1st bonding strength was not sufficiently obtained.

## Claims

**1.** An Al connection material containing 3.0 mass% or more and 12.0 mass% or less of Si, wherein,

when crystal orientations of an Al phase in an L cross-section (cross section in a center axis direction including a center axis) of the Al connection material are measured, a total of orientation ratios of a <111> crystal orientation and a <110> crystal orientation angled at 15° or less to the center axis direction is equal to or larger than 20% and equal to or smaller than 70%, provided that, when the total of the orientation ratios is equal to or smaller than 25%, an orientation ratio of the <110> crystal orientation angled at 15° or less to the center axis direction is equal to or larger than 5%, and
when crystal orientations of a Si phase in the L cross-section of the Al connection material are measured, a total of orientation ratios of the <111> crystal orientation and the <110> crystal orientation angled at 15° or less to the center axis direction is equal to or larger than 20% and equal to or smaller than 70%.

**2.** The Al connection material according to claim 1, wherein, regarding crystal orientations of the Al phase in the L cross-section, an orientation ratio of the <110> crystal orientation angled at 15° or less to the center axis direction is equal to or larger than 5% and equal to or smaller than 40%.

**3.** The Al connection material according to claim 1 or 2, wherein an average diameter of the Al phase in the L cross-section is equal to or larger than 5 μm and equal to or smaller than 40 μm.

**4.** The Al connection material according to any one of claims 1 to 3, wherein an average value of a ratio between a short side length e and a long side length f (e/f) of the Si phase in the L cross-section is equal to or larger than 0.2 and equal to or smaller than 0.7.

**5.** The Al connection material according to any one of claims 1 to 4, further containing 10 mass ppm or more and 800 mass ppm or less of one or more of Sr, Ca, Eu, and Sb in total.

**6.** The Al connection material according to any one of claims 1 to 5, further containing 10 mass ppm or more and 500 mass ppm or less of one or more of Ni, Mg, Fe, and In in total.

**7.** The Al connection material according to any one of claims 1 to 6, wherein a total concentration of other elements in the Al connection material is equal to or smaller than 0.5 mass%.

FIG.1

L CROSS-SECTION
(CROSS SECTION IN
CENTER AXIS DIRECTION
INCLUDING CENTER AXIS)
CENTER AXIS OF
Al CONNECTION MATERIAL

FIG.2

f
Si PHASE
e
CENTER AXIS DIRECTION OF
Al CONNECTION MATERIAL

FIG.3

BROKEN PART
K
J
HOLLOW

**INTERNATIONAL SEARCH REPORT**

International application No. **PCT/JP2024/020313**

**A. CLASSIFICATION OF SUBJECT MATTER**

***H01L 21/60***(2006.01)i; ***C22C 21/02***(2006.01)i; ***C22F 1/00***(2006.01)i; ***C22F 1/043***(2006.01)i
FI: H01L21/60 301F; C22C21/02; C22F1/00 605; C22F1/00 614; C22F1/00 625; C22F1/00 630G; C22F1/00 650A; C22F1/00 661Z; C22F1/00 681; C22F1/00 682; C22F1/00 685Z; C22F1/00 686A; C22F1/00 691B; C22F1/00 691C; C22F1/00 691Z; C22F1/00 694A; C22F1/00 694Z; C22F1/043

According to International Patent Classification (IPC) or to both national classification and IPC

**B. FIELDS SEARCHED**

Minimum documentation searched (classification system followed by classification symbols)

H01L21/60; C22C21/02-21/04; C22F1/00; C22F1/043

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2020/184655 A1 (NIPPON MICROMETAL CORPORATION) 17 September 2020 (2020-09-17) | 1-7 |
| A | WO 2022/168787 A1 (NIPPON MICROMETAL CORPORATION) 11 August 2022 (2022-08-11) | 1-7 |
| A | WO 2019/031497 A1 (NIPPON STEEL CHEMICAL & MATERIAL CO., LTD.) 14 February 2019 (2019-02-14) | 1-7 |
| A | WO 2019/031498 A1 (NIPPON STEEL CHEMICAL & MATERIAL CO., LTD.) 14 February 2019 (2019-02-14) | 1-7 |
| E, X | WO 2024/122380 A1 (NIPPON STEEL CHEMICAL & MATERIAL CO., LTD.) 13 June 2024 (2024-06-13)<br>claims 1-6, paragraph [0058] | 1-7 |

☐ Further documents are listed in the continuation of Box C.　　☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 July 2024** | **30 July 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/020313**

| Patent document cited in search report | Publication date (day/month/year) | Patent family member(s) | Publication date (day/month/year) |
|---|---|---|---|
| WO 2020/184655 A1 | 17 September 2020 | US 2022/0152749 A1 | |
| | | EP 3940757 A1 | |
| | | CN 113557596 A | |
| | | KR 10-2021-0138019 A | |
| | | TW 202040708 A | |
| WO 2022/168787 A1 | 11 August 2022 | US 2024/0071978 A1 | |
| | | EP 4289983 A1 | |
| | | CN 116918049 A | |
| | | TW 202235634 A | |
| WO 2019/031497 A1 | 14 February 2019 | US 2020/0168578 A1 | |
| | | EP 3667709 A1 | |
| | | TW 201921531 A | |
| | | CN 110998814 A | |
| | | KR 10-2020-0039714 A | |
| WO 2019/031498 A1 | 14 February 2019 | US 2020/0279824 A1 | |
| | | EP 3667710 A1 | |
| | | TW 201920701 A | |
| | | CN 111033706 A | |
| | | KR 10-2020-0039726 A | |
| WO 2024/122380 A1 | 13 June 2024 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014131010 A
- JP 2014129578 A
- JP 59057440 A
- JP 2020150116 A